# EUROPÄISCHE PATENTANMELDUNG

(11) **EP 4 236 131 A2**
(43) Veröffentlichungstag der Anmeldung: **30.08.2023**
(21) Anmeldenummer: 23180788.4
(22) Anmeldetag: 21.06.2023
(51) Int. Cl.: H04L 1/00, H04L 25/49

(54) **VERFAHREN UND SYSTEMANORDNUNG ZUR VERBESSERUNG DER VORWÄRTSFEHLERKORREKTUR BEI SERIELLER KODIERUNG IN EINER DATENÜBERTRAGUNG**

(71) Anmelder: Inova Semiconductors, 81671 München (DE)
(72) Erfinder: Kluge, Fabian, Perasdorf (DE); Neumann, Roland, Bad Tölz (DE)
(74) Vertreter: Reich, Jochen

(57) **Zusammenfassung**

Die vorliegende Erfindung ist auf ein Verfahren zur Verbesserung der Vorwärtsfehlerkorrektur bei serieller Kodierung bei einer Datenübertragung im Fahrzeug gerichtet und schafft gegenüber dem Stand der Technik unter anderem den Vorteil, dass trotz einer Reduzierung des Ressourcenbedarfs das physikalische Verhalten auf einem Übertragungskanal stets deterministisch kontrollierbar ist. So sind gemäß dem vorgeschlagenen Verfahren die Bitfehler minimal und ein Übertragungsfehler kann effizient, d.h. mit minimalem technischem Aufwand, korrigiert werden. Darüber hinaus sind die verwendeten Kodierer bezüglich ihrer Anzahl der Gatter minimal ausgestaltet und es ist dem vorgeschlagenen Verfahren eine Verschachtelung implizit, die darauf abstellt, dass sogenannte Burst Fehler besonders vorteilhaft korrigiert werden können. Diese implizite Verschachtelung ermöglicht es, dass die benötigten herkömmlichen Pufferspeicher einer expliziten Verschachtelung entfallen können. Darüber hinaus wird erfindungsgemäß sichergestellt, dass Nutzdaten mitsamt korrigierender Metadaten vorteilhaft bezüglich der Übertragung kodiert werden können. Erfindungsgemäß kann sichergestellt werden, dass nicht nur die Nutzdaten linienkodiert bzw. leitungskodiert werden, sondern eben auch die Korrekturdaten. Die vorliegende Erfindung ist ebenfalls auf eine analog ausgestaltete Systemanordnung zur Durchführung des Verfahrens gerichtet sowie auf ein Computerprogrammprodukt mit Steuerbefehlen, welche das Verfahren ausführen.

## Beschreibung

Die vorliegende Erfindung ist auf ein Verfahren zur Verbesserung der Vorwärtsfehlerkorrektur bei serieller Kodierung bei einer Datenübertragung im Fahrzeug gerichtet und schafft gegenüber dem Stand der Technik unter anderem den Vorteil, dass trotz einer Reduzierung des Ressourcenbedarfs das physikalische Verhalten auf einem Übertragungskanal stets deterministisch kontrollierbar ist. So sind gemäß dem vorgeschlagenen Verfahren die Bitfehler minimal und ein Übertragungsfehler kann effizient, d.h. mit minimalem technischem Aufwand, korrigiert werden. Darüber hinaus sind die verwendeten Kodierer bezüglich ihrer Anzahl der Gatter minimal ausgestaltet und es ist dem vorgeschlagenen Verfahren eine Verschachtelung implizit, die darauf abstellt, dass sogenannte Burst Fehler besonders vorteilhaft korrigiert werden können. Diese implizite Verschachtelung ermöglicht es, dass die benötigten herkömmlichen Pufferspeicher einer expliziten Verschachtelung entfallen können. Darüber hinaus wird erfindungsgemäß sichergestellt, dass Nutzdaten mitsamt korrigierender Metadaten vorteilhaft bezüglich der Übertragung kodiert werden können. Erfindungsgemäß kann sichergestellt werden, dass nicht nur die Nutzdaten linienkodiert bzw. leitungskodiert werden, sondern eben auch die Korrekturdaten. Die vorliegende Erfindung ist ebenfalls auf eine analog ausgestaltete Systemanordnung zur Durchführung des Verfahrens gerichtet sowie auf ein Computerprogrammprodukt mit Steuerbefehlen, welche das Verfahren ausführen.

Aus dem Stand der Technik sind unterschiedliche Versionen des Ethernet-Protokolls bekannt. Ethernet verwendet eine Vielzahl von Techniken, um Fehler während der Datenübertragung zu erkennen und zu korrigieren. Die Fehlerkorrekturmechanismen sind Teil des Ethernet-Protokolls und gewährleisten, dass die empfangenen Daten korrekt und vollständig sind. Cyclic Redundancy Check (CRC) ist eine der wichtigsten Fehlererkennungstechniken in Ethernet. Bei CRC wird eine Prüfsumme über die gesendeten Daten berechnet und an das Paket angehängt. Beim Empfänger wird die Prüfsumme erneut berechnet und mit der empfangenen Prüfsumme verglichen. Wenn die Prüfsummen nicht übereinstimmen, wird ein Fehler erkannt, und das Paket wird verworfen.

Ferner ist aus dem Stand der Technik die sogenannte Vorwärtsfehlerkorrektur bekannt. Forward Error Correction (FEC) ist eine Methode zur Fehlerkorrektur, bei der zusätzliche Redundanzinformationen zu den Daten hinzugefügt werden. Diese Redundanz ermöglicht es dem Empfänger, Fehler zu erkennen und zu korrigieren, ohne dass das Paket erneut gesendet werden muss. FEC wird oft in Hochgeschwindigkeits-Ethernet-Verbindungen wie 10 Gigabit Ethernet (10GbE) eingesetzt, um die Datenintegrität sicherzustellen.

Ferner ist aus dem Stand der Technik die Link-Level-Fehlerkorrektur bekannt. Auf der physikalischen Ebene kann Ethernet auch Fehlerkorrekturen durchführen. Hier werden Techniken wie Signalverstärkung, Rauschunterdrückung und Fehlerkorrekturcodes verwendet, um die Stabilität der Datenübertragung zu verbessern. Diese Fehlerkorrekturmechanismen sind in den Ethernet-Transceivern implementiert, die die Umwandlung zwischen digitalen Daten und physikalischen Signalen durchführen.

Fehlerkorrekturmechanismen spielen eine entscheidende Rolle bei der Gewährleistung einer zuverlässigen Datenübertragung in Netzwerken. Sie helfen, Übertragungsfehler zu erkennen, zu isolieren und zu korrigieren, um sicherzustellen, dass die Datenintegrität erhalten bleibt. Insbesondere in geschäftskritischen Umgebungen, in denen große Datenmengen übertragen werden, sind Fehlerkorrekturmechanismen unerlässlich, um die Qualität der Verbindung aufrechtzuerhalten.

Darüber hinaus ist der DisplayPort Standard bekannt. DisplayPort verwendet verschiedene Methoden zur Fehlererkennung und -korrektur, um sicherzustellen, dass die übertragenen Daten genau und ohne Verluste wiedergegeben werden. Diese Mechanismen sind Teil des DisplayPort-Protokolls und tragen zur Stabilität und Qualität der Datenübertragung bei. Forward Error Correction (FEC) ist eine wichtige Fehlerkorrekturmethode bei DisplayPort. Dabei werden zusätzliche Redundanzinformationen in die übertragenen Daten eingefügt. Diese Redundanz ermöglicht es dem Empfänger, fehlerhafte Datenbits zu erkennen und zu korrigieren. Auf diese Weise können Fehler, die während der Übertragung auftreten, effektiv behoben werden, ohne dass die Daten erneut gesendet werden müssen.

Darüber hinaus ist es aus dem Stand der Technik generell bekannt, dass eine Datenübertragung über einen seriellen Datenkanal typischerweise fehlerbehaftet ist. Um diesem Problem zu begegnen, kennt der Stand der Technik unterschiedliche Kodierungen, wie zum Beispiel ein Line Coding. Dies wird auch als eine Leitungskodierung bezeichnet.

Der Stand der Technik erkennt das Problem der fehlerhaften Datenübertragung über einen seriellen Kommunikationslink und sieht hierbei vor, dass die leitungskodierten Daten mit einer Vorwärtsfehlerkorrektur versehen werden. Der Stand der Technik begegnet also dem Problem der Fehlerkorrektur dadurch, dass leitungskodierte Daten mit einem nichtleitungskodiertem Zusatz versehen werden, nämlich der Vorwärtsfehlerkorrektur, welche wiederum nicht leitungskodiert ist. Somit besteht also im Stand der Technik das Problem, dass selbst falls eine Leitungskodierung vorgesehen ist, einzelne Metadaten nicht kodiert übertragen werden und somit eben nicht die Vorteile der Leitungskodierung von allen übertragenen Daten genutzt werden können. Dies stellt wiederum eine Fehlerquelle dar. Der Stand der Technik behilft sich teilweise damit, dass sodann die Vorwärtsfehlerkorrekturdaten gesondert leitungskodiert werden und danach übertragen werden. Somit entsteht ein additiver Aufwand und um die leitungskodierten Vorwärtsfehlerkorrekturdaten abzusichern müsste hierüber eine neue Vorwärtsfehlerkorrektur berechnet werden. Dies schafft wiederum zusätzlichen Aufwand und schafft zudem wiederum eine nicht leitungskodierten Vorwärtsfehlerkorrektur.

Darüber hinaus besteht im Stand der Technik das Problem, dass die Vorwärtsfehlerkorrektur stets über gesamte Datenwörter berechnet wird, sodass ein enormer technischer Aufwand dadurch entsteht, dass eine exponentiell wachsende Anzahl von Gattern bezüglich einer steigenden Wortlänge vorgehalten und betrieben werden muss. Hierdurch sind die Kodierer gemäß dem Stand der Technik, welche die Vorwärtsfehlerkorrektur berechnen, extrem teuer in der Herstellung und zudem Fehler anfälliger. Darüber hinaus nehmen diese große Mengen an Energie auf, was gerade im Fahrzeug nicht gewünscht ist. Ebenfalls propagieren Fehler bezüglich eines gesamten Wortes größer als wenn Fehlerkorrekturen über Teilwörter gebildet werden würden, was wiederum zu einer erhöhten Fehleranfälligkeit führt. Auch dies ist im Fahrzeug nicht gewünscht, da die Datenübertragung gerade im Fahrzeug sicherheitskritisch ist. Die Fehleranfälligkeit kommt also gerade in einem Automobil oder generell einem Fahrzeug stark zu tragen, da sicherheitskritische Funktionen bereitgestellt werden müssen.

Aus dem Stand der Technik sind unterschiedliche Kodierungsverfahren bzw. Datenübertragungsverfahren bekannt, welche sich jedoch allesamt auf Anwendungsszenarien beziehen, welche in einem Automobil nur nachteilig Einsatz finden können. So geht der Stand der Technik oftmals davon aus, dass eine hohe Rechenleistung verfügbar ist und keine hohen Echtzeitanforderungen gestellt werden. Darüber hinaus geht der Stand der Technik oftmals davon aus, dass ein Gewicht bzw. eine Ausfallsicherheit der zu verwendenden Komponenten eine untergeordnete Rolle spielt. Oftmals bezieht sich der Stand der Technik auf herkömmliche Computernetzwerke, bei denen die Ausfallsicherheit bzw. ein geringer technischer Aufwand weniger von Bedeutung sind.

Ausgehend von diesem Stand der Technik besteht ein Bedarf ein Verfahren bzw. eine Systemanordnung zu schaffen, welche es ermöglicht, dass aufgrund der Sicherheitsanforderungen im Automobil Daten möglichst schnell verarbeitet werden können und zudem ein geringer technischer Aufwand besteht und die Fehlerrate bei der Übertragung minimiert ist, da eine erneute Übertragung bei Fehlererkennung nicht möglich ist. Der geringe technische Aufwand soll darin bestehen, dass möglichst einfache Komponenten zu verbauen sind, welche wenig Gewicht aufweisen und zudem in großer Stückzahl effizient herstellbar sind. Bekannte Verfahren und Systemanordnungen aus der Computernetzwerktechnik sind hier typischerweise nicht verwendbar, da bei einem Stand-PC bzw. Server Gewichtseinsparungen und Echtzeitlaufverhalten nicht ausschlaggebend sind. Generell spielt zwar bei Rechneranordnungen die abzutransportierende Wärme eine Herausforderung dar, die Energieeffizienz in einem Automobil ist jedoch von nochmals übergeordneter Rolle, da beispielsweise in der Elektromobilität der Stromverbrauch sogar auf die Reichweite des Automobils Einfluss hat.

Weiterer Stand der Technik bezieht sich auf die Übertragung von Daten in einem seriellen Datenstrom. Hierzu sieht der Stand der Technik beispielsweise vor, dass mit den Nutzdaten umfangreiche Beschreibungsdaten mitgesendet werden, welche angeben, wo sich die Nutzdaten befinden bzw. wie die zu interpretieren sind. Darüber hinaus ist es im Stand der Technik bekannt, einzelne Datenpakete zu verwerfen, wenn diese nicht ordnungsgemäß übertragen werden. Darüber hinaus ist es im Stand der Technik bekannt Datenpakete erneut zu versenden, falls diese nicht rechtzeitig bzw. in einem unerwarteten Format bei einem Sender eintreffen.

Bei der seriellen Übertragung von Daten ist es notwendig die Anzahl von Einsen und Nullen im seriellen Datenstrom möglichst gleich zu haben. Dies nennt man die Disparität. Eine Disparität von Null im großen Mittel und aber auch über einen kleinen Zeitraum ist wünschenswert, damit es nicht zu einem sogenannten Baseline Drift bei der Übertragung kommt. Der Baseline Drift (Gleichspannungsschwankung) des seriellen Signals führt zu Bitfehlern. Im Extremfall ist eine Übertragung nicht möglich.

Um die seriellen Bits im seriellen Datenstrom, sicher auf der Empfangsseite zurückgewinnen zu können, ohne die Notwendigkeit einen Takt mit zu übertragen, ist eine Mindestanzahl von 0->1 beziehungsweise 1->0 Übergängen notwendig. Damit wird der Takt zur Rückgewinnung der seriellen Daten lokal am Empfänger aus dem seriellen Datenstrom erzeugt. Die sogenannte Lauflänge (Run Length) gibt an, wieviel gleiche Bits (Einsen oder Nullen) hintereinander, ohne Wechsel vorkommen können. Eine kleine Lauflänge ist immer wünschenswert, da große Lauflängen eine sichere Rückgewinnung des Taktes aus dem seriellen Datenstrom nicht mehr ermöglichen.

Die Aufgabe des Line Codes (in diesem Fall ein Block Code bzw. Leitungskode) ist es nun aus beliebigen Datenwörtern mit beliebiger Disparität und unendlicher Lauflänge ein Symbol mit garantierter Disparität und garantierter Lauflänge zu erzeugen. Dies führt zu einem Overhead bei der Übertragung. Es müssen also mehr Bits (in Form von Symbolen) übertragen werden als in dem netto zu übertragenden Daten Wort vorkommen. Das führt dazu, dass die benötigte Übertragungsgeschwindigkeit (Bandbreite) größer sein muss als die Datenrate der zu übertragenden Daten. Dies führt wiederum dazu, dass Systeme höhere Fehlerraten oder mehr Aufwand, Strom, etc. benötigen, als zur Übertragung der Rohdaten notwendig wäre.

Es ist daher eine Aufgabe der vorliegenden Erfindung ein Verfahren zur Verbesserung der Vorwärtsfehlerkorrektur bei serieller Kodierung bei einer Datenübertragung in einem Fahrzeug vorzuschlagen. Das vorgeschlagene Verfahren soll effizient, mit geringem technischem Aufwand und möglichst Fehler robust ausgestattet werden. Darüber hinaus ist es eine Aufgabe der vorliegenden Erfindung eine entsprechend eingerichtete Systemanordnung zur Durchführung des Verfahrens bereitzustellen. Ferner ist es eine Aufgabe der vorliegenden Erfindung ein Computerprogrammprodukt vorzuschlagen, welches Steuerbefehle vorhält, die das Verfahren umsetzen bzw. die Systemanordnung betreiben. Darüber hinaus soll ein Speichermedium vorgeschlagen werden mit Steuerbefehlen.

Die Aufgabe wird gelöst mit den Merkmalen des Patentanspruchs 1. Weitere vorteilhafte Ausgestaltungen sind in den Unteransprüchen angegeben.

Demgemäß wird ein Verfahren zur Verbesserung der Vorwärtsfehlerkorrektur bei serieller Kodierung bei einer Datenübertragung im Fahrzeug vorgeschlagen, aufweisend ein Bereitstellen von zu übertragenden Nutzdaten; ein Aufteilen der bereitgestellten Nutzdaten in eine Mehrzahl von Bitfolgen jeweils gleicher Länge; ein Auslesen einer Unterteilungsvorschrift, welche eine Bitfolge in eine Abfolge von Segmenten jeweils vordefinierter Länge an vorbestimmter Bitposition unterteilt; ein Anwenden der ausgelesenen Unterteilungsvorschrift auf alle Bitfolgen der Mehrzahl von Bitfolgen; ein iteratives Erstellen jeweils einer Teilvorwärtsfehlerkorrektur für alle Segmente gleicher Bitposition über alle Bitfolgen; ein iteratives Anwenden jeweils eines Segmentkodierers über jeweils alle Segmente gleicher Bitposition zur Erzeugung von Segmentleitungskodes über alle Segmente je Bitposition und je Bitfolge; ein Anwenden jeweils desjenigen Segmentkodierers auf die jeweilige Teilvorwärtsfehlerkorrektur, der auch für die Segmente angewendet wurde bezüglich derer die jeweilige Teilvorwärtsfehlerkorrektur erstellt wurde zur Erzeugung jeweils eines Teilvorwärtsfehlerkorrekturleitungskodes je Teilvorwärtsfehlerkorrektur; und ein Übertragen aller Segmentleitungskodes und aller Teilvorwärtsfehlerkorrekturleitungskodes.

Erfindungsgemäß wird die Vorwärtsfehlerkorrektur dadurch verbessert, dass diese bezüglich Nutzdaten errechnet wird und dass hierzu erst die Nutzdaten segmentiert werden. Für jedes Segment wird sodann eine eigene Vorwärtsfehlerkorrektur berechnet, sodass sich die Vorwärtsfehlerkorrektur nicht auf ein gesamtes Datenwort bezieht, sondern auf unterschiedliche Teilwörter. Hierdurch wird die Gatteranzahl der zu verwendenden FEC Kodierer gering gehalten und es wird ein exponentielles Wachstum vermieden. Darüber hinaus ergibt sich eine Verbesserung dadurch, dass erfindungsgemäß eine Leitungskodierung über die Nutzdaten mitsamt der Vorwärtsfehlerkorrektur erfolgt und somit wird der Nachteil im Stand der Technik überwunden, dass die Vorwärtsfehlerkorrektur in einer nicht kodierten Form übermittelt wird. Weiterhin ist es vorteilhaft, dass die Fehlerkorrektur effizienter arbeiten kann, da sich die Fehlerkorrektur lediglich auf Teilwörter bezieht und somit feingranular erkannt werden kann, wo ein Fehler aufgetreten ist. Herkömmliche Fehlerkorrekturen beziehen sich stets auf gesamte Datenwörter und sind daher ineffizient bzw. kann es in dem Stand der Technik zu Fehlern kommen die nicht korrigierbar sind. Dies wird durch die Segmentierung erfindungsgemäß vermieden.

Eine weitere Verbesserung besteht darin, dass alle übertragenen Daten leitungskodiert werden und somit kann die Gesamtheit der Daten von der Leitungskodierung profitieren. Der Übertragungslink ist somit deterministisch kontrollierbar und die Bitfehler werden minimal gehalten. Darüber hinaus ergibt sich eine implizite Verschachtelung daraus, dass kleinere Pakete versendet werden und somit kommt es implizit zu einer Verschachtelung, da nicht die gesamten Datenwörter übertragen werden. Dies wird dadurch erreicht, dass mehrere Vorwärtsfehlerkorrekturkodierer verwendet werden, die sich jeweils nur auf Teilwörter beziehen. Somit wird erfindungsgemäß der Nachteil im Stand der Technik überwunden, dass aufwendig eine explizite Verschachtelung geschaffen werden muss, welche zudem weitere Pufferspeicher benötigen würde.

Aufgrund der optimierten Disparität (Leitungskodierung) der zu übertragenden Bitfolge ist es möglich, dass Fehler bei einem Interpretieren auf einem seriellen Kanal vermieden werden. Somit bezieht sich die Effizienz auch darauf, dass die Bitfolge besonders fehlerrobust ist und somit kann diese verlässlicher Weise lediglich einmal übertragen werden. Eine redundante Übertragung wird aufgrund der hohen Erkennbarkeit, wiederum aufgrund der optimierten Disparität, vermieden.

Bei der seriellen Übertragung von Daten ist es vorteilhaft, die Anzahl von Einsen und Nullen im seriellen Datenstrom möglichst in gleicher Anzahl vorzuhalten. Dies wird generell als Disparität bezeichnet. Für eine zuverlässige Taktwiederherstellung am Empfänger kann der erzeugten Kanalsequenz eine Lauflängenbeschränkung auferlegt werden. Hierdurch wird die maximale Anzahl aufeinanderfolgender Einsen und Nullen begrenzt. Somit kann das vorgeschlagene Verfahren auch als ein Verfahren zum effizienten Kodieren einer Bitfolge bezeichnet werden. Erfindungsgemäß wird die Disparität durch ein geschicktes Einstellen von Teil- Disparitäten optimiert. Dies kann besonders vorteilhaft dann Anwendung finden, wenn die Lauflänge der Bitfolge beschränkt ist. Die eingeschränkte Disparität und die eingeschränkte Lauflänge können sich auch auf die bereitgestellte beliebige Bitfolge beziehen. Somit muss es sich hierbei nicht um die effizient übertragbare Bitfolge handeln. Insgesamt ist die bereitgestellte beliebige Bitfolge effizient übertragbar bzw. aus dieser Bitfolge wird eine zu übertragende Bitfolge generiert bzw. erzeugt, welche sodann effizient übertragbar ist.

Das vorgeschlagene Verfahren ist speziell im Fahrzeug einsetzbar bzw. speziell auf den Bedarf im Fahrzeug zugeschnitten. Dies ist deshalb der Fall, da im Fahrzeug sicherheitskritische Funktionen angeboten werden, welche entsprechend abgesichert werden müssen. Erfindungsgemäß erfolgt das in mehrfacher Weise. Zum einen durch die Vorwärtsfehlerkorrektur sowie über die Leitungskodierung. Darüber hinaus wirkt sich gerade in der Elektromobilität die verringerte Anzahl an benötigten Gattern vorteilhaft aus.

Erfindungsgemäß erfolgt in einem vorbereitenden Verfahrensschritt ein Bereitstellen von zu übertragenden Nutzdaten. Hierbei handelt es sich typischerweise um eine Bitfolge in festgelegter Länge. Dies kann auch als ein Datenwort bezeichnet werden.

Sodann erfolgt ein Aufteilen der bereitgestellten Nutzdaten in eine Mehrzahl von Bitfolgen jeweils gleicher Länge. Diese Bitfolgen können in einem bevorzugten Ausführungsbeispiel eine Länge von 112 Bit aufweisen. Während es sich bei den Nutzdaten um einen kontinuierlichen Datenstrom handeln kann, sind die Bitfolgen stets von bestimmter Länge und stellen in gewisser Weise eine Unterteilung der Nutzdaten bereit. Im Folgenden wird eine Bitfolge auch als ein Datenwort bezeichnet. Weiterhin wird im Folgenden, insbesondere auch in den Figuren, davon ausgegangen, dass bildlich gesprochen die Bitfolgen untereinander angeordnet werden. Somit erstreckt sich also jede einzelne Bitfolge horizontal und vertikal werden die einzelnen Bitfolgen untereinander angeordnet.

Da die Bitfolgen nunmehr segmentiert werden, erfolgt ein Auslesen einer Unterteilungsvorschrift, welche eine Bitfolge in eine Abfolge von Segmenten jeweils vordefinierter Länge an vorbestimmter Position unterteilt. Die Unterteilungsvorschrift kann als ein Datenformat vorliegen, welches definiert, wie lange ein Segment sein muss. Hierbei müssen die einzelnen Segmente nicht gleicher Länge sein, sondern dies kann von Segment zu Segment variieren. Die Unterteilungsvorschrift sieht jedoch vor, dass die einzelnen Bitfolgen je vom gleichen Format sind, so dass sich bildlich gesprochen vertikal gleiche Unterteilungen ergeben. So kann beispielsweise ein erstes Segment jeder Bitfolge 11 Bit aufweisen. Beispielsweise können auch die ersten vier Segmente jeweils 11 Bit aufweisen, woraufhin ein Segment von 7 Bit folgt. Daraufhin kann wieder ein Segment mit 11 Bit vorgesehen sein und dann ein Segment von 6 Bit. Dieses Datenformate wird für alle Bitfolgen eingehalten. Somit können also die Segmente an gleicher Position immer von gleicher Länge sein, wobei sich die Segmente bildlich gesprochen vertikal unterscheiden können. Die Segmente bildlich gesprochen je Zeile formen sodann die Bitfolge. Die Bitfolgen in ihrer vertikalen Anordnung bilden in ihrer Gesamtheit die Nutzdaten.

Somit erfolgt also ein Anwenden der ausgelesenen Unterteilungsvorschrift auf alle Bitfolgen der Mehrzahl von Bitfolgen, bis die gesamten Nutzdaten horizontal gesprochen in Bitfolgen zerlegt sind und vertikal die Segmente gebildet sind. Somit werden also alle Bitfolgen gemäß gleicher Unterteilungsvorschrift unterteilt. Die Unterteilungsvorschrift kann aus einem Datenspeicher ausgelesen werden und gilt für alle Bitfolgen, die aus den Nutzdaten gewonnen worden.

Nunmehr erfolgt ein iteratives Erstellen jeweils einer Teilvorwärtsfehlerkorrektur für alle Segmente gleicher Bitposition über alle Bitfolgen. Somit wird also wiederum bildlich gesprochen für alle vertikalen Segmente eine Vorwärtsfehlerkorrektur berechnet, die sich also auf alle Segmente an gleicher Bitposition bzw. gleicher Reihenfolge befinden. Dies wird für alle Segmente durchgeführt, sodass über alle Bitfolgen und somit über die kompletten Nutzdaten jeweils Teilvorwärtsfehlerkorrekturen erstellt wurden. Die Gesamtheit aller Teilvorwärtsfehlerkorrekturen schafft somit eine gesamte Vorwärtsfehlerkorrektur, die sich auf die kompletten Nutzdaten bzw. alle Bitfolgen bezieht.

Generell ist es auch möglich, dass die Nutzdaten lediglich in eine Bitfolge aufgeteilt werden bzw. dass die Nutzdaten bereits in ihrer Länge als eine Bitfolge vorliegen. Somit wird dann für jedes Segment eine Teilvorwärtsfehlerkorrektur erzeugt.

Nunmehr erfolgt ein iteratives Anwenden jeweils eines Segmentkodierers über jeweils alle Segmente gleicher Bitposition zur Erzeugung von Segmentleitungskodes über alle Segmente je Bitposition und je Bitfolge. Es erfolgt also eine Leitungskodierung über bildlich gesprochen alle vertikalen Segmente. Dies ist insofern vorteilhaft, da Leitungskodierer speziell für vorbestimmte Längen vorgesehen werden. Hierdurch wird sichergestellt, dass die vertikalen Segmente jeweils durch einen einzelnen Leitungskodierung kodiert werden können. Das iterative Anwenden der Segmentkodierer stellt also sicher, dass bildlich gesprochen spaltenweise die Segmente leitungskodiert werden und dies erfolgt über alle Segmente derart, bis alle Bitfolgen bezüglich ihrer Segmente leitungskodiert sind.

Besonders vorteilhaft ist es, dass die Teilvorwärtsfehlerkorrektur die gleiche Anzahl aufweist, wie die jeweiligen Segmente. Somit kann die Teilvorwärtsfehlerkorrektur mittels des gleichen Leitungskodierers kodiert werden, wie die entsprechenden Segmente.

Es erfolgt ein Anwenden jeweils desjenigen Segmentkodierers auf die jeweilige Teilvorwärtsfehlerkorrektur, der auch für die Segmente angewendet wurde bezüglich derer die jeweilige Teilvorwärtsfehlerkorrektur erstellt wurde zur Erzeugung jeweils eines Teilvorwärtsfehlerkorrekturleitungskodes je Teilvorwärtsfehlerkorrektur. Somit werden also diejenigen Segmentkodierer verwendet, die die jeweiligen Segmente leitungskodiert haben und sodann auch die jeweiligen Teilvorwärtsfehlerkorrekturen leitungskodieren. Somit werden also die Segmente spaltenweise mit dem gleichen Segmentkodierer leitungskodiert wie die Teilvorwärtsfehlerkorrekturen, die sich auf die jeweilige Spalte beziehen.

Daraufhin erfolgt eine Übertragung aller Segmentleitungskodes und aller Teilvorwärtsfehlerkorrekturleitungskodes.

Gemäß einem Aspekt der vorliegenden Erfindung wird die Unterteilungsvorschrift in einem Datenspeicher abgespeichert und liegt als eine Kodierungsvorschrift vor und/ oder wird aus einer Hardwarearchitektur ausgelesen. Dies hat den Vorteil, dass die Unterteilungsvorschrift statisch vorgegeben sein kann bzw. auch in dem Datenspeicher geändert werden kann.

Darüber hinaus kann die Unterteilungsvorschrift auf die entsprechende Hardwarearchitektur Rücksicht nehmen. Werden beispielsweise unterschiedliche Kodierer für unterschiedliche Bitlängen vorgehalten, so können die Bitfolgen derart unterteilt werden, dass die entsprechenden Segmente den jeweiligen Kodierern entsprechen. Die Segmente haben also genau diese Länge, die der jeweilige Kodierer vorsieht.

Gemäß einem weiteren Aspekt der vorliegenden Erfindung weisen alle Bitfolgen in ihrem Datenformat den gleichen Aufbau auf, haben die gleichen Segmentlängen und/ oder die gleichen Bitpositionen. Dies hat den Vorteil, dass die einzelnen Segmente den jeweiligen Kodierern zugeführt werden können. So wird beispielsweise jedes erste Segment jeder Bitfolge dem gleichen Kodierer zugeführt. Somit können bildlich gesprochen die Segmente spaltenweise kodiert werden und es liegt für jede Spalte ein spezialisierter Kodierer vor.

Gemäß einem weiteren Aspekt der vorliegenden Erfindung weist die Teilvorwärtsfehlerkorrektur eine Korrekturinformation auf, welche einen Sollinhalt des Segments beschreibt über das die Teilvorwärtsfehlerkorrektur erstellt wurde. Dies hat den Vorteil, dass mittels dieser Korrekturdaten die übermittelten Daten korrigiert werden können, wobei nicht für jede Bitfolge eine gesamte Korrektur gebildet wird, sondern vielmehr werden für die einzelnen Segmente einzelne Teilvorwärtsfehlerkorrekturen gebildet. Alle Teilvorwärtsfehlerkorrekturen in ihrer Gesamtheit beschreiben alle Segmente aller Bitfolgen und somit alle Nutzdaten. Der Unterschied zum Stand der Technik hierbei ist jedoch, dass nicht für jede Bitfolge eine Vorwärtsfehlerkorrektur gebildet wird, sondern für alle Segmente über alle Bitfolgen. Somit ist es möglich für jede Teilvorwärtsfehlerkorrektur den gleichen Leitungskodierer zu verwenden, der für die entsprechenden Segmente verwendet wird.

Gemäß einem weiteren Aspekt der vorliegenden Erfindung weist die Teilvorwärtsfehlerkorrektur die gleiche Bitlänge auf wie das Segment über welches diese erstellt wird. Dies hat den Vorteil, dass spezialisierte Leitungskodierer vorgehalten werden können und somit wird eine maximale Effizienz dahingehend geschaffen, dass die entsprechenden spaltenweisen Leitungskodierer genau für die Bitlänge spezialisiert sind, die sie sodann auch kodieren müssen. Somit wird ein effizientes und technisch minimal aufwändiges Verfahren geschaffen.

Gemäß einem weiteren Aspekt der vorliegenden Erfindung beschreibt eine Gesamtheit der Teilvorwärtsfehlerkorrekturen alle zu übertragenden Nutzdaten in korrigierbarer Weise. Dies hat den Vorteil, dass alle Nutzdaten, welche übertragen werden bezüglich ihrer Fehler korrigiert werden können, hierbei jedoch auf die einzelnen Segmente abgestellt werden kann, so dass das vorgeschlagene Verfahren feingranularer ist, als dies der Stand der Technik vorsieht.

Gemäß einem weiteren Aspekt der vorliegenden Erfindung erzeugen die Segmentkodierer jeweils mindestens einen Teil eines Leitungskodes. Dies hat den Vorteil, dass die Ausgaben der Segmentkodierer zusammengefügt werden können und sodann die zu übertragenden Leitungskodes bereitstellen.

Gemäß einem weiteren Aspekt der vorliegenden Erfindung kodiert die Gesamtheit der Segmentkodierer Bitfolgen von 112 Bit in Wörter von 128 Bit. Dies hat den Vorteil, dass ein besonders effizienter Line Code bzw. Leitungskode geschaffen wird.

Gemäß einem weiteren Aspekt der vorliegenden Erfindung werden bei dem Übertragen an die Segmentleitungskodes die Teilvorwärtsfehlerkorrekturleitungskodes angehängt. Dies hat den Vorteil, dass alle zu übertragenden Daten leitungskodiert sind und somit wird die Leitung deterministisch betrieben bzw. die Vorteile der Leitungskodierung kann für alle Daten in Anspruch genommen werden und eben nicht nur für die Nutzdaten an sich.

Gemäß einem weiteren Aspekt der vorliegenden Erfindung ist die Bitposition als ein Offset oder als ein Bitindex in der Bitfolge angegeben. Dies hat den Vorteil, dass unterschiedliche Adressierungsarten verwendet werden können und der Index auf eine Reihenfolge der jeweiligen Segmente abstellt, welche sodann vorteilhaft und unter Verwendung von bekannten Verfahren angegeben werden kann.

Gemäß einem weiteren Aspekt der vorliegenden Erfindung liegen die Nutzdaten als ein serieller Datenstrom vor. Dies hat den Vorteil, dass theoretisch eine beliebige Menge an Nutzdaten übertragen werden kann, welche sodann in Bitfolgen gleicher Länge unterteilt wird.

Gemäß einem weiteren Aspekt der vorliegenden Erfindung werden die Verfahrensschritte in der beschriebenen Reihenfolge ausgeführt und/ oder iterativ ausgeführt. Dies hat den Vorteil, dass die Reihenfolge der Kodierung umgekehrt wird. Erfindungsgemäß ist es vorgesehen, dass zuerst die Vorwärtsfehlerkorrektur erstellt wird und sodann erfolgt die Leitungskodierung. Dies schließt nicht aus, dass einzelne Verfahrensschritte mehrfach durchgeführt werden müssen. Dies kann beispielsweise dann sein, wenn mehrere Bitfolgen vorliegen und diese segmentiert werden müssen.

Gemäß einem Aspekt der vorliegenden Erfindung wird für jeweils jeden Datenteilwörterblock und/ oder jeweils jede Datenteilwörterblockvorwärtsfehlerkorrektur ein Leitungskodesegment erzeugt. Dies hat den Vorteil, dass gerade die Vorwärtsfehlerkorrektur nicht unkodiert übermittelt werden muss, sondern vielmehr wird auch diese leitungskodiert. Somit stehen die Vorteile der Leitungskodierung nicht nur für die Nutzdaten zur Verfügung sondern eben auch für die Vorwärtsfehlerkorrektur.

Gemäß einem weiteren Aspekt der vorliegenden Erfindung wird eine Vorwärtsfehlerkorrektur für einen Datenblock aus mehreren Teilvorwärtsfehlerkorrekturen der Datenteilwörterblöcke zusammengesetzt. Dies hat den Vorteil, dass nicht eine gesamte Vorwärtsfehlerkorrektur initial erzeugt wird, sondern viele einzelne Teilvorwärtsfehlerkorrekturen, die in ihrer Gesamtheit eine Gesamtvorwärtsfehlerkorrektur bilden. Auf diese Art und Weise wird die Gatteranzahl der benötigten FEC Kodierer minimal gehalten. Dennoch ist es möglich, alle Daten mittels einer Vorwärtsfehlerkorrektur zu schützen und darüber hinaus die Daten mitsamt Vorwärtsfehlerkorrektur FEC leitungskodiert zu übermitteln.

Gemäß einem weiteren Aspekt der vorliegenden Erfindung wird die Datenstruktur ausgelesen und in Abhängigkeit der jeweiligen Bitlängen der Datenteilwörter je ein Vorwärtsfehlerkorrekturteilkodierer gewählt. Dies hat den Vorteil, dass die FEC Kodierer genau auf die Segmentlängen bzw. die Bitlängen der Teilwörter zugeschnitten sind. Auf diese Art und Weise ist es möglich, dass die Gatteranzahl derart minimiert wird, dass die Kodierer lediglich für kleine Teilwörter Kodierungen erstellen müssen und eben nicht für die gesamten Datenwörter. Folglich ist jeder FEC Kodierer genau auf die Bitlänge des zu kodierenden Datenteilworts zugeschnitten.

Gemäß einem weiteren Aspekt der vorliegenden Erfindung wird die Anzahl der Gatter der FEC - Teilkodierer in Abhängigkeit einer Bitlänge der Datenteilwörter gewählt. Dies hat den Vorteil, dass gegenüber dem Stand der Technik die Anzahl der Gatter, die bei den FEC - Kodierern benötigt wird, reduziert wird und somit wird eine effiziente Systemanordnung bzw. ein effizientes Verfahren geschaffen, welches gerade im Automobil bzw. im Fahrzeug vorteilhaft ist. Auf diese Art und Weise müssen keine Gatter vorgehalten werden, die nicht notwendig wären. Somit hat man eine deterministische und minimale Anzahl an Gattern.

Gemäß einem weiteren Aspekt der vorliegenden Erfindung wird die Anzahl aller Gatter aller Kodierer derart gewählt, dass sich bei iterativer Ausführung des Verfahrens eine lineare Erhöhung der Gatteranzahl bezüglich ansteigender Datenwortlängen ergibt. Dies hat den Vorteil, dass unter Berücksichtigung des Datenformats eine minimale Anzahl an Gattern bereitgestellt wird bzw. dass bereits das Datenformat derart gewählt werden kann, dass nur eine lineare Steigerung bei der Anzahl der Gatter notwendig ist. So kann in einem Ausführungsbeispiel die maximale Bitlänge 10,11 oder 12 Bit sein, was dazu führt, dass die benötigten Gatter bzw. Schaltkreise der FEC Kodierer lediglich linear ansteigen. Da bei größeren Werten ein exponentielles Wachstum an Gattern notwendig ist schafft die vorliegende Erfindung den technischen Effekt, dass der Stromverbrauch bzw. die Energieaufnahme minimiert wird, was wiederum zu weniger Abwärme führt. Darüber hinaus ist das vorgeschlagene Verfahren besonders robust, was gerade im Automobil vorteilhaft ist, da hier sicherheitskritische Funktionen angeboten werden.

Gemäß einem weiteren Aspekt der vorliegenden Erfindung weist jedes Datenwort 112 Bit auf. Dies hat den Vorteil, dass bei einer Leitungskodierung Wörter von 128 Bit geschaffen werden können, was einem gängigen Format entspricht. Erfindungsgemäß wurde gezeigt, dass sich gerade 112 Bit besonders Fehler robust 128 Bit kodieren lassen. Somit ist Sorge getragen, dass der Übertragung ein verlustbehafteter bzw. fehlerbehafteter Datenkanal unterliegt.

Gemäß einem weiteren Aspekt der vorliegenden Erfindung wird die Bitlänge der Datenteilwörterblockvorwärtsfehlerkorrektur derart gewählt, dass diese mit der Bitlänge der Datenteilwörter übereinstimmt. Dies hat den Vorteil, dass sowohl die Vorwärtsfehlerkorrektur als auch die Datenteilwörter bzw. Segmente den gleichen Kodierer kodiert werden können, wobei es sich hierbei um den Leitungskodierer, also nicht den FEC Kodierer, handelt. Somit schafft die vorliegende Erfindung den technischen Beitrag, dass nicht nur eine minimale Gatteranzahl vorzuhalten ist, sondern vielmehr wird auch die Anzahl der Kodierer insgesamt minimiert. So kann die Vorwärtsfehlerkorrektur mit den gleichen Kodierer leitungskodiert werden, wie die tatsächlichen Segmente der Nutzdaten.

Gemäß einem weiteren Aspekt der vorliegenden Erfindung wird die Datenteilwörterblockvorwärtsfehlerkorrektur und der Datenteilwörterblock auf Basis dessen die Datenteilwörterblockvorwärtsfehlerkorrektur berechnet wird mittels dem gleichen Leitungskodierers leitungskodiert. Dies hat den Vorteil, dass eine minimale Anzahl an Leitungskodierung vorzuhalten ist. Bildlich gesprochen werden quasi alle Spalten, d.h. alle Teilwörterblöcke mitsamt der entsprechenden Teilvorwärtsfehlerkorrektur mit jeweils dem gleichen Segmentkodierer leitungskodiert.

Gemäß einem weiteren Aspekt der vorliegenden Erfindung wird die Datenstruktur in Abhängigkeit der Bitlänge der Datenwörter gewählt. Dies hat den Vorteil, dass dynamisch auch zur Laufzeit auf die unterschiedlichen Bitlängen eingegangen werden kann und somit kann für weitere Datenwörter das gleiche Datenformat gewählt werden, wie für ein erstes bereitgestelltes Datenwort. Liegen erste Datenwörter vor, so kann bei einem weiteren seriellen Datenstrom eine entsprechende Datenstruktur angewendet werden und die weiteren Datenwörter werden derart strukturiert, dass sie den Datenstrukturen der zuerst erhaltenen Datenwörtern entsprechen.

Gemäß einem weiteren Aspekt der vorliegenden Erfindung erfolgt eine serielle Leitungskodierung nach dem Berechnen der Datenteilwörterblockvorwärtsfehlerkorrektur. Dies hat den Vorteil, dass die Reihenfolge, wie sie im Stand der Technik vorgesehen ist, umgekehrt wird und es wird zuerst die Vorwärtsfehlerkorrektur berechnet, was dazu führt, dass diese eben auch leitungskodiert werden kann und nicht unverschlüsselt bzw. unkodiert übermittelt werden muss.

Gemäß einem weiteren Aspekt der vorliegenden Erfindung werden die Verfahrensschritte virtualisiert ausgeführt und Informationen über die zugrunde liegenden Kodierer und/ oder Gatter erzeugt. Dies hat den Vorteil, dass in einem vorbereitenden Verfahrensschritt die Ausführungen evaluiert werden können und insofern kann festgestellt werden, wie viele Gatter bzw. wie viele FEC Kodierer und/ oder Leitungskodierer vorzuhalten sind. Darüber hinaus kann das Verfahren insgesamt simuliert werden. Hardwarekomponenten können virtuell bereitgestellt werden.

Die Aufgabe auch gelöst durch eine Systemanordnung zur Verbesserung der Vorwärtsfehlerkorrektur bei serieller Kodierung bei einer Datenübertragung im Fahrzeug, aufweisend eine Schnittstelleneinheit eingerichtet zum Bereitstellen von zu übertragenden Nutzdaten; eine Aufteilungseinheit eingerichtet zum Aufteilen der bereitgestellten Nutzdaten in eine Mehrzahl von Bitfolgen jeweils gleicher Länge; eine weitere Schnittstelleneinheit eingerichtet zum Auslesen einer Unterteilungsvorschrift, welche eine Bitfolge in eine Abfolge von Segmenten jeweils vordefinierter Länge an vorbestimmter Bitposition unterteilt; eine Unterteilungseinheit eingerichtet zum Anwenden der ausgelesenen Unterteilungsvorschrift auf alle Bitfolgen der Mehrzahl von Bitfolgen; eine Korrektureinheit eingerichtet zum iterativen Erstellen jeweils einer Teilvorwärtsfehlerkorrektur für alle Segmente gleicher Bitposition über alle Bitfolgen; eine Kodiereinheit eingerichtet zum iterativen Anwenden jeweils eines Segmentkodierers über jeweils alle Segmente gleicher Bitposition zur Erzeugung von Segmentleitungskodes über alle Segmente je Bitposition und je Bitfolge; eine weitere Kodiereinheit eingerichtet zum Anwenden jeweils desjenigen Segmentkodierers auf die jeweilige Teilvorwärtsfehlerkorrektur, der auch für die Segmente angewendet wurde bezüglich derer die jeweilige Teilvorwärtsfehlerkorrektur erstellt wurde zur Erzeugung jeweils eines Teilvorwärtsfehlerkorrekturleitungskodes je Teilvorwärtsfehlerkorrektur; und eine Übertragungseinheit eingerichtet zum Übertragen aller Segmentleitungskodes und aller Teilvorwärtsfehlerkorrekturleitungskodes.

Die vorliegende Erfindung ist ebenso gerichtet auf eine Systemanordnung bzw. ein Verfahren, welches die Daten in Empfang nimmt und sodann dekodiert und sowohl die Vorwärtsfehlerkorrektur ausliest als auch die Nutzdaten.

Die Aufgabe wird auch gelöst durch ein Computerprogrammprodukt mit Steuerbefehlen, welche das vorgeschlagene Verfahren implementieren beziehungsweise die vorgeschlagene Vorrichtung betreiben.

Erfindungsgemäß ist es besonders vorteilhaft, dass das Verfahren zum Betreiben der vorgeschlagenen Vorrichtungen und Einheiten verwendet werden kann. Ferner eignen sich die vorgeschlagenen Vorrichtungen und Einrichtungen zur Ausführung des erfindungsgemäßen Verfahrens. Somit implementiert jeweils die Vorrichtung strukturelle Merkmale, welche geeignet sind, das entsprechende Verfahren auszuführen. Die strukturellen Merkmale können jedoch auch als Verfahrensschritte ausgestaltet werden. Auch hält das vorgeschlagene Verfahren Schritte zu Umsetzung der Funktion der strukturellen Merkmale bereit. Darüber hinaus können physische Komponenten gleicherweise auch virtuell bzw. virtualisiert bereitgestellt werden.

Weitere Vorteile, Merkmale und Einzelheiten der Erfindung ergeben sich aus der nachfolgenden Beschreibung, in der unter Bezugnahme auf die Zeichnungen Aspekte der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Ebenso können die vorstehend genannten und die hier weiter ausgeführten Merkmale je für sich oder zu mehreren in beliebigen Kombinationen Verwendung finden. Funktionsähnliche oder identische Bauteile oder Komponenten sind teilweise mit gleichen Bezugszeichen versehen. Die in der Beschreibung der Ausführungsbeispiele verwendeten Begriffe "links", "rechts", "oben" und "unten" beziehen sich auf die Zeichnungen in einer Ausrichtung mit normal lesbarer Figurenbezeichnung bzw. normal lesbaren Bezugszeichen. Die gezeigten und beschriebenen Ausführungsformen sind nicht als abschließend zu verstehen, sondern haben beispielhaften Charakter zur Erläuterung der Erfindung. Die detaillierte Beschreibung dient der Information des Fachmanns, daher werden bei der Beschreibung bekannte Schaltungen, Strukturen und Verfahren nicht im Detail gezeigt oder erläutert, um das Verständnis der vorliegenden Beschreibung nicht zu erschweren. In den Figuren zeigen:
- Figur 1:: mehrere Beispiele eines Verfahrensablaufs mit serieller Kodierung und Berechnung einer Vorwärtsfehlerkorrektur gemäß dem Stand der Technik;
- Figur 2:: ein optimierter Verfahrensablauf mit einer Vorwärtsfehlerkorrektur und einer seriellen Kodierung gemäß einem Aspekt der vorliegenden Erfindung;
- Figur 3:: ein Kodieren von Nutzdaten sowie ein Berechnen einer Vorwärtsfehlerkorrektur gemäß dem Stand der Technik;
- Figur 4:: ein Verfahren zur Verbesserung der Vorwärtsfehlerkorrektur bei serieller Kodierung bei einer Datenübertragung im Fahrzeug gemäß der vorliegenden Erfindung;
- Figur 5:: eine Gegenüberstellung der Kodierung gemäß Stand der Technik und dem Verfahren zur Verbesserung der Vorwärtsfehlerkorrektur gemäß einem Aspekt der vorliegenden Erfindung;
- Figur 6:: ein Diagramm, welches die benötigte Anzahl an Gattern je Bitlänge von Vorwärtsfehlerkorrekturen verdeutlicht;
- Figur 7A:: ein Kodieren von Nutzdaten in einen Leitungskode gemäß einem Aspekt der vorliegenden Erfindung;
- Figur 7B:: die vorgeschlagene Systemanordnung zur Verbesserung der Vorwärtsfehlerkorrektur bei serieller Kodierung bei einer Datenübertragung im Fahrzeug gemäß einem Aspekt der vorliegenden Erfindung;
- Figur 8A:: einen Aspekt des Verfahrens zur Verbesserung der Vorwärtsfehlerkorrektur gemäß einem Aspekt der vorliegenden Erfindung auf Senderseite;
- Figur 8B:: ein Verfahren zur Verbesserung der Vorwärtsfehlerkorrektur auf Empfängerseite gemäß am Aspekt der vorliegenden Erfindung; und
- Figur 9:: ein Ablaufdiagramm eines Verfahrens zur Verbesserung der Vorwärtsfehlerkorrektur bei serieller Kodierung bei einer Datenübertragung gemäß am Aspekt der vorliegenden Erfindung.

Die vorliegenden Figuren weisen teilweise Parameter auf, welche dem Fachmann in der englischen Bezeichnung so geläufig sind und welche als Parameter verwendet werden und so nicht zu übersetzen sind.

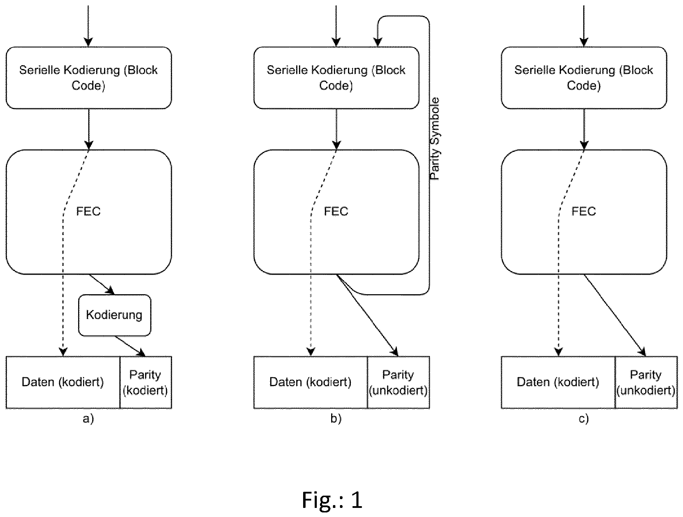

Figur 1 zeigt drei Ausführungsbeispiele, wie gemäß herkömmlicher Verfahren eine Vorwärtsfehlerkorrektur durchgeführt wird. Auf der linken Seite ist ein Ausführungsbeispiel gezeigt, welches zuerst eine serielle Kodierung der Nutzdaten durchführt und sodann einen Vorwärtsfehlerkorrekturcode FEC erzeugt. Die seriell kodierten Daten werden übermittelt und im Nachgang wird die Vorwärtsfehlerkorrektur kodiert und dann an die kodierten Nutzdaten angehängt. Somit wird also gemäß diesem Beispiel aus dem Stand der Technik über ein komplettes Datenwort die Vorwärtsfehlerkorrektur erzeugt und diese muss sodann erneut kodiert werden und wird angehängt. Es wird also nicht über die einzelnen Segmente kodiert, sondern über die Bitfolge im Ganzen.

In der Mitte ist ein weiteres Ausführungsbeispiel aus dem Stand der Technik gezeigt, wobei der Schritt der Leitungskodierung der Vorwärtsfehlerkorrektur ausgelassen wird und eine nicht kodierte Paritätsinformation angehängt wird. Hier entsteht der Nachteil, dass der letzte Datenteil, also die Paritätsinformation nicht leitungskodiert ist und somit stark fehlerbehaftet ist.

Auf der rechten Seite ist ein Beispiel gezeigt, welches im Gegensatz zu dem Ausführungsbeispiel in der Mitte die Rückschleife der Paritätsinformation zur seriellen Kodierung unterlässt. Hierbei ergeben sich die gleichen Nachteile, wie bei dem Beispiel in der Mitte.

Datenübertragungslösungen stellen stets striktere Anforderungen an Fehlerfreiheit/Fehlertoleranz die bei stets steigenden Datenraten eine feine Abstimmung zwischen serieller Kodierung und Forward-Error-Correction (FEC) benötigen.

Der aktuelle Stand der Technik (Ethernet / DisplayPort) verarbeitet den Datenstrom in folgender Reihenfolge:
1. Die Eingangsdaten werden im ersten Schritt mittels serieller Kodierung (8b10b, 64b66b, 128b132b etc.) kodiert. Bei größeren Kodierungen ab 64b66b aufwärts wird dies primär durch Scrambling mittels LFSR erreicht.
2. Der serielle kodierte Strom wird nun mittels FEC (Forward Error Correction) Kodierung zusätzlich vor Bitfehlern geschützt. Eine komplette FEC-Kodierung (FEC-Kodierungs-Wort) beinhaltet sowohl die Eingangsdaten auf Symbolbasis als auch zusätzlich die sogenannten Paritäts-Symbole. Die Eingangsdaten werden für diese Anwendungen durch den FEC unberührt hindurchgereicht. D.h. sie entsprechen stets dem ursprünglichen seriellen Code. Es gibt nun folgende weitere Vorgehensweisen:
   a. Die Parity Symbole werden nun ebenfalls im Nachhinein noch seriell kodiert (z.B. 8b10b) um die Anforderungen für eine serielle Übertragung zu erfüllen (Lauflänge, DC-Balance etc.). Dieses zusätzliche Kodieren der Parity Symbole im Nachhinein benötigt einen weiteren Kodierer in Hardware.
   b. Anstelle der genannten nachträglichen seriellen Kodierung der Parity-Symbole gibt es ebenfalls Lösungen mit Rückkopplung der Parity-Symbole zu Schritt 1.). Bei einem Seriellen-Kodierer besteht die Möglichkeit basierend auf der Wahl eines positiven bzw. negativen Symbols die DC-Balance zu steuern. Dies ist allerdings mit entsprechender Totzeit (in Abhängigkeit der Größen von serieller Kodierung und des FEC-Kodierers) verbunden. Dies kann z.B. betragsmäßig zu einer starken Abweichung der temporären DC-Balancierung führen.
   c. Die Parity Symbole werden unbehandelt direkt auf den seriellen Link gegeben (z.B. DisplayPort 2.0). Dies ist allerdings sehr ungenau da die Paritäts-Symbole in Abhängigkeit der Eingangsdaten entstehen. Man verlässt sich hier darauf, dass die Paritäts-Symbole im Mittel DC-Balanciert sind.

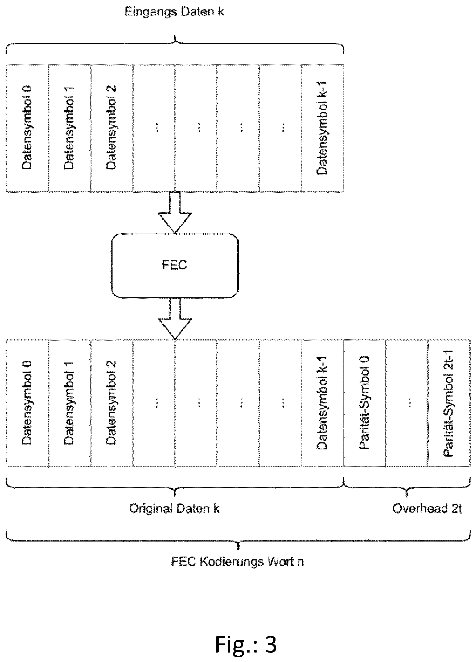

Alle genannten Verfahren (a-c) haben den Nachteil, dass sie einen großen Ressourcenbedarf haben (z.B. zwei serielle Kodierer) oder zu einer ungenügend genauen seriellen Kodierung führen (z.B. DC-Balancierung, Lauflänge, Spektrum). Speziell die ungenaue Kontrolle über die serielle Kodierung kann in Kombination mit dem Übertragungskanal dazu führen, dass empfängerseitig der Datenstrom nicht fehlerfrei rekonstruiert werden kann (CDR sampelt falsch). Diese Effekte werden im Betrieb mit FEC abgeschwächt (da dieser Bit-/Symbolfehler korrigiert), was der FEC-Kodierung unnötigerweise mit jedem Fehler, der durch die schlechte serielle Kodierung entsteht, Korrektur-Marge für weitere nötige Fehlerkorrektur für Fehler, die durch Signalintegrität oder z.B. äußere Einwirkungen entstehen, nimmt. Ein Reed Solomon FEC kann basierend auf der Größe des Overheads (2t siehe Figur 3) in Symbolen nur t Symbolfehler korrigieren.

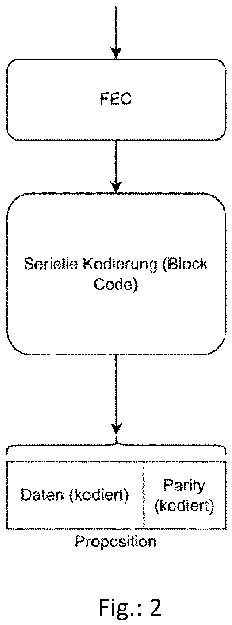

Figur 2 hingegen zeigt das erfindungsgemäße Verfahren, bei dem über die Nutzdaten Vorwärtsfehlerkorrekturen erzeugt werden und diese werden dann ebenfalls mit den Nutzdaten kodiert. Der Vorteil besteht hierin, dass sowohl die Nutzdaten als auch die Vorwärtsfehlerkorrektur leitungskodiert sind und somit Fehler robust sind. Anhand dieser Figur wird ebenfalls ersichtlich, dass der Unterschied zum Stand der Technik darin besteht, dass die Vorwärtsfehlerkorrektur direkt auf den Nutzdaten erzeugt werden und nicht eben auf den leitungskodierten Nutzdaten. Dies ermöglicht es sodann alle Daten leitungskodiert zu übertragen, was wiederum eine erhöhte Fehlerrobustheit mit sich bringt.

Das im Weiteren vorgeschlagene Verfahren zur Verbesserung genannter Problematik gilt für alle denkbaren ECC/FEC Kodierungen und ist nicht nur bei Reed Solomon Codes anwendbar.

Das vorgestellte Verfahren ändert die Reihenfolge von serieller Kodierung und FEC:
1. Die Eingangsdaten werden im ersten Schritt mittels FEC bzw. mehreren individuellen FEC-Einheiten kleinerer Symbolbreite (6-12 Bit) geschützt. Dies führt hier ebenfalls insgesamt zu dem Overhead 2t.
   Die Verwendung von mehreren FEC-Sub-Kodierungen wird hier ausdrücklich präferiert, da dies weiter positive Eigenschaften mit sich bringt (wird im Folgenden erläutert).
2. Anschließend wird das oder die jeweiligen aktuellen FEC-Ausganssymbole (nicht zu verwechseln mit dem gesamten FEC Kodierungs-Wort n) mittels Block Code so kodiert, dass alle gewünschten Eigenschaften an DC-Balance, Lauflänge, Frequenzspektrum etc. eingehalten werden.
   Im Falle von mehreren FEC-Kodieren im Schritt 1.) wird hier mit exakt derselben Anzahl an Block Kodierern gearbeitet. Dies führt auf der Empfangsseite dazu, dass sich ein Bitfehler auf dem Link, der ein komplettes Datensymbol des seriellen Codes zerstört, zu nur einem einzigen FEC-Symbolfehler führt.

Figur 3 zeigt ein Ablaufdiagramm gemäß dem Stand der Technik, wobei die Eingangsdaten leitungskodiert werden und sodann wird eine Vorwärtsfehlerkorrektur erzeugt. Diese Vorwärtsfehlerkorrektur wird, wie ganz unten eingezeichnet ist, auf der vorliegenden rechten Seite angehängt. Somit wird also zuerst das Datenwort oben leitungskodiert und sodann wird ein nicht leitungskodierter Vorwärtsfehlerkorrektur angehängt. Dies stellt nunmehr ein Problem dar, da die Vorwärtsfehlerkorrektur nicht die gewünschten Eigenschaften aufweist, die zu einer robusten Datenübertragung notwendig sind. Es ergeben sich also dadurch Nachteile, dass die Daten nicht DC (digital current) balanciert sind, also eine vorteilhafte Parität nicht eingestellt ist. Darüber hinaus kann es bei einer nicht leitungskodierten Übertragung Fehler bei der Taktwiederherstellung geben. Generell ist eine Leitungskodierung dahingehend vorteilhaft, dass ein Mittelwert derjenigen analogen Signale gemessen werden kann und sodann kann geprüft werden, welche tatsächlichen Signale sich über diesem Mittelwert befinden und welche darunter. Hierbei ist es wünschenswert, dass die Anzahl der analogen Signale über dem Mittelwert, also digitale "1", gleich der Anzahl der analogen Signale unter dem Mittelwert, also digitale "0", entspricht. Somit kann eine optimierte Signalmodellierung durchgeführt werden. Dies ist in der vorliegenden Figur 3 nicht möglich, da der Vorwärtsfehlerkorrekturkode nicht leitungskodiert wird.

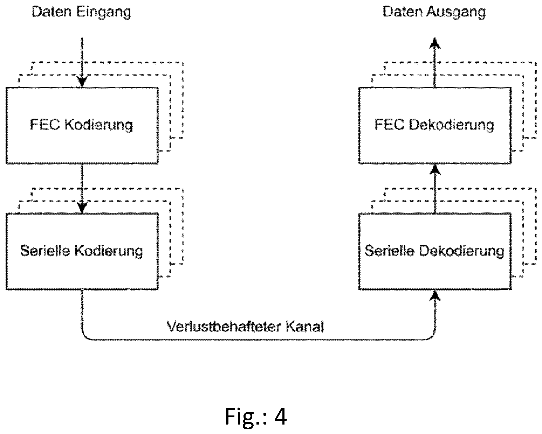

Figur 4 zeigt das erfindungsgemäße Vorgehen und das Übertragen über einen verlustbehafteten Kanal. Hierbei ist jeder Kanal potenziell Verlust behaftet und es ist besonders vorteilhaft, dass bei dem Dateneingang zuerst die Vorwärtsfehlerkodierung erfolgt und sodann die gesamte serielle Kodierung erfolgt. Auf Empfängerseite wird das Verfahren analog invers ausgeführt und es erfolgt zuerst eine serielle Dekodierung, wodurch neben den Nutzdaten auch die Vorwärtsfehlerkorrektur wiederhergestellt wird.

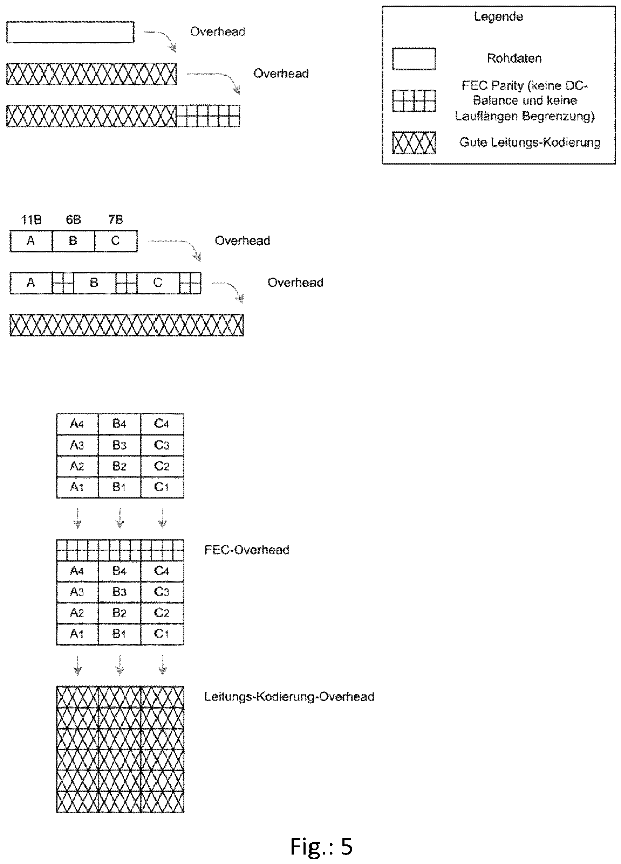

Figur 5 zeigt in einem oberen Ausführungsbeispiel ein Verfahren gemäß dem Stand der Technik, wobei in einem ersten Verfahrensschritt von der ersten auf die zweite Zeile ein Ausgangsdatenwort bzw. eine Bitfolge leitungskodiert wird. Hieraus entsteht ein Kode der länger ist als die Ausgangsbitfolge, was vorliegend als auch Overhead bezeichnet wird. In einem darauffolgenden Verfahrensschritte wird von der zweiten Zeile auf die dritte Zeile ein Vorwärtsfehlerkorrekturkode erzeugt, der der Leitungskodierung angefügt wird. Wie nunmehr ersichtlich ist, ist der erste Teil links der zu übertragenen Daten leitungskodiert und der zweite Teil, nämlich die Vorwärtsfehlerkorrektur ist nicht leitungskodiert. Dies bringt Probleme mit sich, da auf die Vorteile der Leitungskodierung bei dem Anhang auf der rechten Seite verzichtet werden muss. Dies ist nachteilig.

In dem Ausführungsbeispiel in der Mitte der vorliegenden Figur ist oben wieder das Ausgangswort ABC eingezeichnet. Die Bitfolge besteht also aus den Segmenten A, B und C. Diese sind vorliegend 11 Bit, 6 Bit und 7 Bit lang. Erfindungsgemäß wird jetzt eben nicht das gesamte Datenwort also die gesamte Bitfolge in ihrer Gesamtheit geschützt, d.h. mit einem Vorwärtsfehlerkorrekturcode versehen, sondern es werden die einzelnen Segmente geschützt. Dies ist in der zweiten Zeile dadurch eingezeichnet, dass nach jedem Segment A, B und C der entsprechende Vorwärtsfehlerkorrekturcode eingezeichnet ist. In einem darauffolgenden Verfahrensschritt wird in der dritten Zeile eine Leitungskodierung angewendet bzw. die Daten aus der zweiten Zeile werden komplett leitungskodiert, was zu einem Leitungskode in der dritten Zeile führt. Dieser kann nunmehr übertragen werden und es ist ersichtlich, dass die gesamten Daten leitungskodiert sind und eben auch der Vorwärtsfehlerkorrekturkode leitungskodiert ist. Somit finden die Vorteile der Leitungskodierung auf sämtliche zu übertragenen Daten Anwendung.

In dem Ausführungsbeispiel ganz unten in Figur 5 sind die erfindungsgemäßen Verfahrensschritte gezeigt, wobei weitere Unterschritte möglich sind. Es sind die unterschiedlichen Bitfolgen eingezeichnet, wobei nunmehr die Nutzdaten in Bitfolgen gleicher Länge unterteilt wurden. Somit wird die Gesamtheit der Nutzdaten in vorliegend vier Bitfolgen unterteilt, welche alle gleicher Länge sind. Diese vorliegend vier Bitfolgen werden wiederum in Segmente gleicher Länge unterteilt. Bildlich gesprochen sind also horizontal einzelne Bitfolgen angeordnet und diese Bitfolgen sind bildlich gesprochen untereinander angeordnet, sodass jede Zeile eine Bitfolge widerspiegelt. Wie ebenfalls ersichtlich ist, sind die Bitfolgen jeweils in drei Segmente gleicher Länge unterteilt. Dies gibt eine matrixartige Anordnung der Nutzdaten in Bitfolgen je Zeile und Segmente je Spalte.

Nunmehr wird eben nicht, wie es im Stand der Technik vorgesehen ist, eine Leitungskodierung durchgeführt, sondern es wird gemäß der Unterteilungsvorschrift, wie sie im oberen Verfahrensschritt vorgegeben ist, je Spalte, d.h. also für alle Segmente an gleicher Bitposition eine Teilvorwärtsfehlerkorrektur errechnet. Wie in der ersten Zeile des zweiten Rechtecks zu sehen ist, ist oben eine Teilvorwärtsfehlerkorrektur eingezeichnet, welche in der vorliegenden Figur in ihrer Gesamtheit als FEC Overhead bezeichnet wird. Nunmehr liegen also die segmentierten Bitfolgen gemäß der Unterteilungsvorschrift vor und es liegen die Teilvorwärtsfehlerkorrekturen für alle Segmente gleicher Bitposition über alle Bitfolgen vor.

Nunmehr erfolgt ein Anwenden jeweils eines Segmentkodierers über jeweils alle Segmente gleicher Bitposition zur Erzeugung von Segmentleitungskodes über alle Segmente je Bitposition und je Bitfolge. In einem weiteren oder in dem gleichen Verfahrensschritt erfolgt ein Anwenden jeweils desjenigen Segmentkodierers auf die jeweilige Teilvorwärtsfehlerkorrektur, der auch für die Segmente angewendet wurde und es ergibt sich somit ein einziger Leitungskode, welcher die Segmentleitungskodes umfasst und die Teilvorwärtsfehlerkorrekturleitungskodes. Wie nunmehr unten in der vorliegenden Figur 5 ersichtlich ist, wurden also alle Daten leitungskodiert und insbesondere wurde auch die Vorwärtsfehlerkorrektur FEC leitungskodiert. Somit können diese Daten nunmehr vorteilhaft übertragen werden.

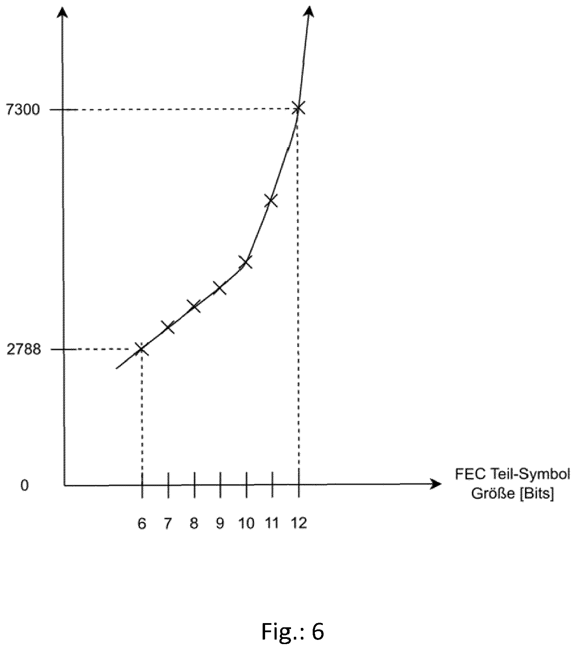

Figur 6 zeigt in einem Diagramm auf der y-Achse die Anzahl der benötigten Gatter bei der Erstellung eines Vorwärtsfehlerkorrekturkodes in Abhängigkeit der zu kodierenden Bitlänge auf der x-Achse. Wie vorliegend ersichtlich ist, handelt es sich hierbei um ein exponentielles Wachstum und ab einer Bitlänge von 10-12 Bit steigt das Wachstum der Gatter, also die Anzahl der benötigten Gatter für die Vorwärtsfehlerkorrekturen, überdurchschnittlich. Somit ist es erfindungsgemäß besonders vorteilhaft die Vorwärtsfehlerkorrektur je Segment auszuführen, da hierdurch vermieden wird, dass das gesamte Datenwort, also die gesamte Bitlänge berücksichtigt werden muss. Würde die gesamte Bitlänge bei der Vorwärtsfehlerkorrektur berücksichtigt werden müssen, so wäre die Bitlänge typischerweise jenseits der kritischen 12 Bit. Die benötigten Gatter in den Vorwärtsfehlerkorrekturkodierer würden in unvorteilhafter Weise ansteigen. Dies verdeutlicht also den vorteilhaften technischen Effekt der vorliegenden Erfindung, die zuerst Segmente über die Bitfolge gebildet und sodann auf den Segmenten die Vorwärtsfehlerkorrektur berechnet.

An dieser Stelle wird nochmals auf die Unterteilungsvorschrift gemäß Figur 5 abgestellt, welche vorsieht, dass ein Segment 11 Bit, 6 Bit oder 7 Bit aufweisen kann.

Durch die Verwendung mehrerer und dadurch von der FEC-Symbolgröße kleinerer FEC-Kodierer/ Dekodierer wird sowohl die Anzahl benötigter Gatter kleiner als auch die maximale Betriebsfrequenz bei gegebenem Prozessknoten Fₘₐₓ größer (kürzere Carry Chains, mehr Parallelität).

In Figur 6 kann der Zusammenhang zwischen der FEC Symbol-Größe in Bits und der benötigten Implementierung gesehen werden. Dies bezieht sich auf eine Hardwareimplementierung eines Reed Solomon FECs. Die Gatter Anzahl ist normalisiert (auf 12 Bit Symbolgröße) es kann somit direkt verglichen werden. Der exponentiell ausgeprägte Zusammenhang zwischen Symbolgröße in Bits und der Implementierung in Gattern kann dem Graphen entnommen werden.

Für die jeweiligen kleinen FEC-Sub-Kodierer müssen hier keineswegs stets die gleichen Symbolbreiten verwendet werden. Große serielle Kodierungen können hier, wie mit der Verwendung für FEC vorgeschlagen, ebenfalls aus mehreren unterschiedlichen Sub-Kodieren (einfachstes Beispiel 8b10b das aus 3b4b und 5b6b aufgebaut werden kann) bestehen. Im Falle der vorliegenden Erfindung bzw. ADXpress (eingetragene Marke) wir dies durch insgesamt 11 Kodierer mit vier Grundtypen: 6b8b, 7b8b, 11 b12b und 11 b13b erreicht. Die für die jeweilige Sub-Kodierung verwendete FEC-Symbolbreite ergibt sich durch die Datenwortbreite des jeweiligen seriellen Kodierers. Für z.B. 6b8b wird entsprechend ein FEC mit Symbolbreite 6 Bit verwendet.

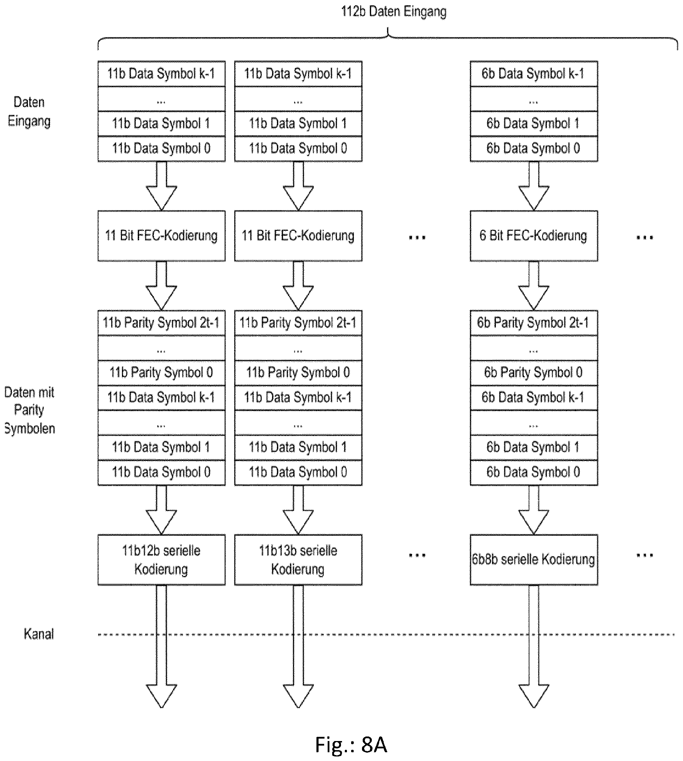

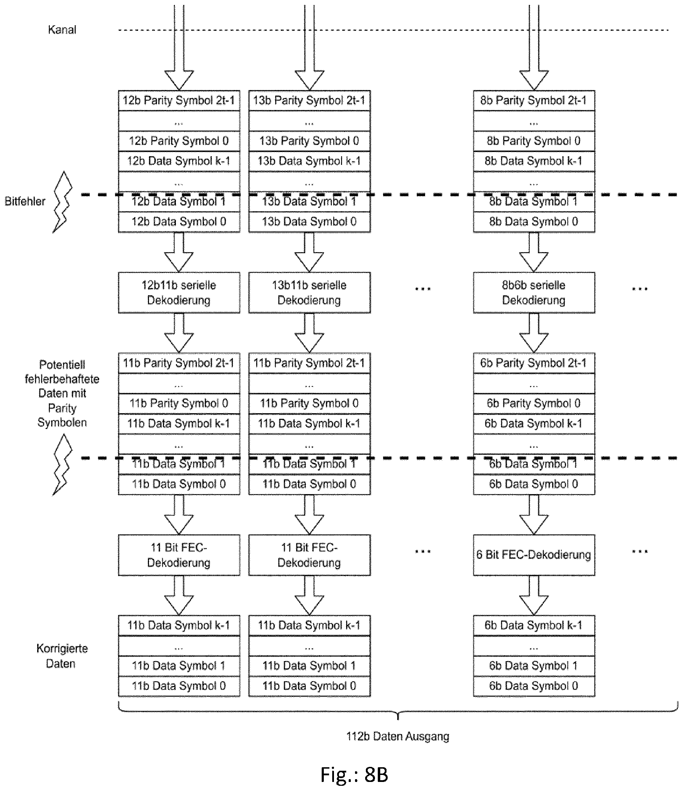

Der komplette Aufbau für den Senderdatenpfad der vorliegenden Erfindung bzw. ADXpress (eingetragene Marke) ist gemäß einem Aspekt in Abbildung 8A dargestellt. Der Datenpfad im Empfänger ist entsprechend invers aufgebaut (siehe auch Figur 8B).

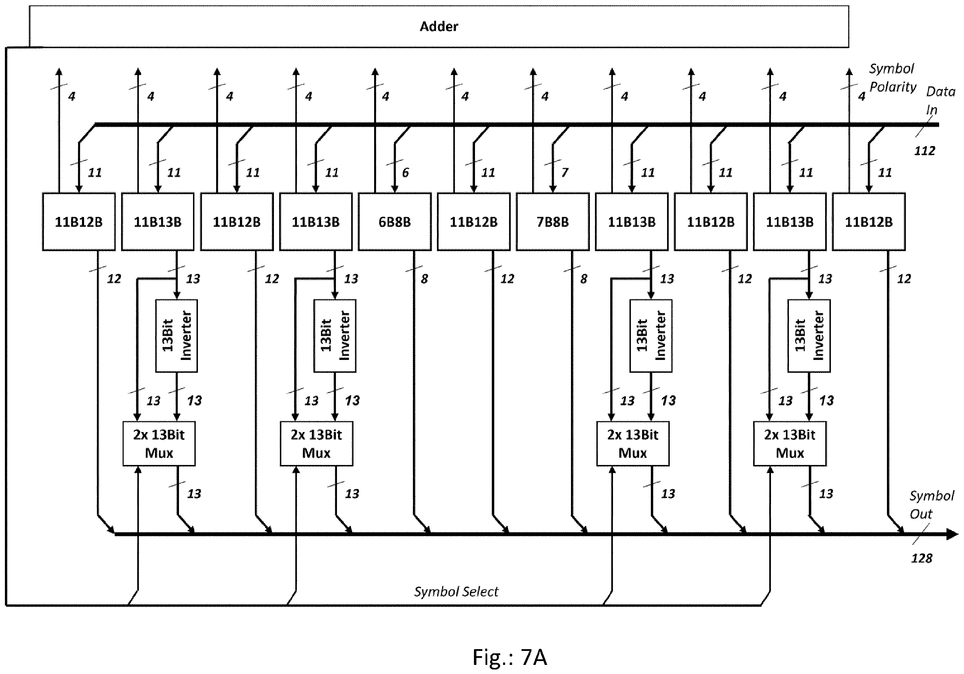

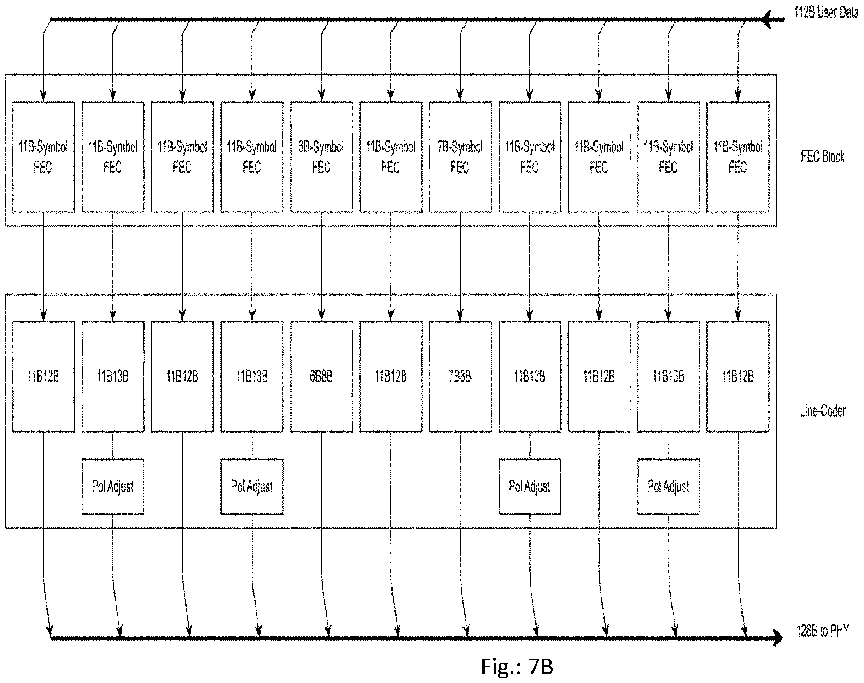

Figur 7A zeigt einen Leitungskodierung bzw. eine Leitungskodierungsvorrichtung mit mehreren Leitungskodierungseinheiten, welche beispielsweise 11 Bit auf 12 Bit abbilden, 11 Bit auf 13 Bit abbilden, oder 11 Bit auf 12 Bit abbilden. Dies entspricht der Reihenfolge in der vorliegenden Figur 7 rechts nach links und verdeutlicht, dass das Eingangsdatenwort, also die Bitfolge oben in einzelne Segmente unterteilt wird und sodann werden die einzelnen Segmente leitungskodiert. Die Berechnung der Vorwärtsfehlerkorrektur ist in der vorliegenden Figur 7A noch nicht berücksichtigt, so dass die Systemanordnung gemäß Figur 7A als Ausgangssystemanordnung für die vorliegende Erfindung dienen kann.

Figur 7A zeigt oben, die beliebige Bitfolge von 112 Bit, welche segmentiert wird, in 11,6 oder 7 Bit. Sodann werden parallel die Kodiereinheiten angesprochen, welche die Bits derart in Teilsymbole überführen, dass diese bezüglich der Disparität optimiert sind. Zum Beispiel werden 11 Bit nach 12 Bit kodiert bzw. 11 Bit nach 13 Bit.

In der vorliegenden Figur 7A ist auf der ganz linken Seite in der Mitte eine Kodiereinheit aus der zweiten Teilmenge eingezeichnet, welche die Bezeichnung 11B12B trägt. Diese liefert ein Teilsymbol mit einem beliebigen Vorzeichen, d. h. also mit einer beliebigen Disparität. Um diese Disparität auszugleichen ist die kodierte Einheit 11 B13B parallel bezüglich der Bitfolge nachgeschaltet. D. h. also, dass ein Datenstrom gebildet wird, der die höherwertigsten Bits von zweimal 11 in zwei Teilsymbole überführt, nämlich einmal wird durch 11B12B das 11 Bit Datensegment in ein 12 Bit Teilsymbol mit beliebigen Vorzeichen, also Disparität, gebildet und einmal wird das Datensegment von 11 Bit in 13 Bit mittels der Kodiereinheit 11B13B kodiert. In der vorliegenden Figur unterhalb der Kodiereinheiten eingezeichnet ist, handelt es sich bei der zweiten Kodiereinheit von links 11B13B um eine Kodiereinheit der ersten Teilmenge. Diese weist einen Inverter und einen Multiplexer auf. Die ersten 13 Bit liegen also als Datenstrom vor, der derart aufgeteilt wird, dass er einmal bezüglich des Vorzeichens, also der Disparität invertiert wird und einmal unverändert bleibt. Weiter unten angezeichnet ist, dass unter Rückkopplung der Disparität derjenige positive oder negative, d. h. der ursprüngliche oder invertierte Datenstrom verwendet wird, der das Vorzeichen aus der ganz linken Kodiereinheit ausgleicht. An dem ersten Multiplexer links liegen also zwei Datenströme an, welche jeweils das Teilsymbol darstellen, einmal mit herkömmlichem Vorzeichen, wie es also aus der Kodiereinheit 11 Bit 13 Bit ausgegeben wird und einmal mit invertierten Vorzeichen bzw. invertierter Disparität.

Aufgrund der Rückkopplung von der Einheit vorliegend ganz oben wird also festgestellt, welche Disparität aus dem ganz linken Kodierer 11B12B resultiert und somit schafft der Multiplexer, vorliegend ganz links unten, einen Ausgleich bzw. eine Minimierung der Disparität des Teilsymbols des ganz linken Kodierers 11B12B. Dies wird parallel derart durchgeführt, dass den Kodiereinheiten aus der zweiten Teilmenge Kodiereinheiten aus der ersten Teilmenge nachgeschaltet werden, welche die Disparität minimieren bzw. eliminieren. Letztendlich wird ganz rechts unten das Gesamtsymbol ausgegeben. Dieses Gesamtsymbol weist 128 Bit auf und ist aus den Teilsymbolen zusammengesetzt, wie sie mittels der geschrägten Pfeile in die fette Linie unten eingefügt werden. Somit liegen also an dieser Ausgabeleitung die Teilsymbole an, welche bezüglich der Disparität optimiert bzw. minimiert sind und diese Teilsymbole Formen das gesamte Symbol, welches sodann ausgegeben und übertragen werden kann.

Die Erfindung kodiert gemäß einem Aspekt der vorliegenden Erfindung ein 112 Bit breites Datenwort, mit beliebiger Disparität (Disparität max: 112) und beliebiger Lauflänge (Lauflänge max: 112), auf ein 128 Bit breites Symbol. Damit beträgt der durch die Kodierung entstehende Overhead 14.2%.

Die maximal in dem Symbol, wie auch bei beliebiger Sequenzierung beliebiger Symbole auftretende Lauflänge beträgt 8 gleiche Bits.

Die maximale Disparität im langen Mittel ist 0. Die Disparität in einem Symbol ist kleiner 9.

Dabei ist die Komplexität der Logik minimal, vergleichbar mit 10 8B/10B Kodierern (mit dem bekannten Nachteil des großen Overheads).

Erreicht wird dies durch den Einsatz, bzw. die parallele Verwendung von mehreren "kleinen" in ihrer Charakteristik bei Disparität und Lauflänge optimal aufeinander abgestimmten Kodierern.

Die Kodierer 11B12B, 7B8B und 6B8B erzeugen alle Symbole mit einer garantierten maximalen Lauflänge von 6, auch bei beliebiger Sequenzierung der (Teil)Symbole.

Der Kodierer (11B13B) erzeugt gemäß einem Aspekt der vorliegenden Erfindung Symbole mit einer garantierten maximalen Lauflänge von 7 bzw. am Anfang oder Ende des Symbols von 5. Auf Grund der Sequenzierung (Abb2) der (11B13B) mit den anderen Codierern kann so maximal eine Lauflänge von 8 im Symbol entstehen.

Siehe Eigenschaften der Kodierer, wie folgt:
- 11B13B: 11 Bit Daten werden auf 2048 Symbole mit 13 Bit abgebildet. Die Symbole können invertiert oder nicht invertiert übertragen werden.
   Disparität:
   +3...+9 oder steuerbar -3...-9
   Lauflänge im Wort: 7
   Lauflänge am Rand: 5.
- 11B13B: 11 Bit Daten werden auf 2048 Symbole mit 13 Bit abgebildet. Die Symbole können invertiert oder nicht invertiert übertragen werden.
   Disparität: +3...+9 oder steuerbar -3...-9
   Lauflänge im Wort: 7
   Lauflänge am Rand: 5
- 11B12B: 11 Bit Daten werden auf 2048 Symbole mit 12 Bit abgebildet. Die Symbole werden nur nicht invertiert übertragen.
   Disparität: -2, -1, 0, 1, 2
   Lauflänge im Wort: 6
   Lauflänge am Rand: 3
- 7B8B: 7 Bit Daten werden auf 128 Symbole mit 8 Bit abgebildet. Die Symbole werden nur nicht invertiert übertragen.
   Disparität: -2, -1, 0, 1, 2
   Lauflänge im Wort: 6
   Lauflänge am Rand: 3
- 6B8B: 6 Bit Daten werden auf 64 Symbole mit 8 Bit abgebildet. Die Symbole werden nur nicht invertiert übertragen.
   Disparität: 0
   Lauflänge im Wort: 6
   Lauflänge am Rand: 3

Mit den vier 11B13B Kodierern kann steuerbar eine Disparität von mindestens +-12 erzeugt werden, um die nicht steuerbare Disparität von maximal +-12 (6 x +-2) der Kodierer 11B12B und 7B8B auszugleichen, so dass unabhängig von den zu übertragenden Daten eine ausgeglichene Disparität sicher erreicht werden kann.

Um die Komplexität der Hardware weiter zu reduzieren, werden gemäß einem Aspekt der vorliegenden Erfindung vier kleine Kodierer (11B13B) verwendet, deren Disparität sich hinsichtlich Vorzeichen (+-) steuern lässt.

Die Steuerung der Symbol-Disparität erfolgt gemäß einem Aspekt der vorliegenden Erfindung derart, dass jeder Kodierer die Parität "seines" Teilsymbols berechnet. Dies geschieht mit wenig Aufwand, da das Teilsymbol nur wenige Bits aufweist.

Bei vier der elf Kodierern kann das Vorzeichen der Disparität des Teilsymbols durch die Invertierung des erzeugten Teilsymbols aktiv gesteuert werden. Dazu weisen die Kodierer (11B13B) die Besonderheit auf, dass deren Symbole für alle Eingangsdaten ein Symbol mit positiver Disparität (+3... +9) erzeugen. Durch Invertierung des Teilsymbols erhält man ein Symbol mit negativer Disparität (-3...-9).

So kann die Disparität (-2,-1,0,1,2) der Teilsymbole der anderen Kodierer (11B12B und 7B8B) kompensiert werden. Der Kodierer 6B8B erzeugt Symbole deren Disparität immer 0 ist. Dann werden alle (Teil) Paritäten der Kodierer (11B12B und 7B8B) addiert und das Ergebnis steuert die Entscheidung, wie viele invertierte und nicht-invertierte Symbole der Kodierer (11B13B) verwendet werden.

Dabei beträgt die mindeste (kleinste) Disparität des Kodierers 11B13B +-3. Also in Summe kann mit diesen vier Kodierern sicher eine Disparität von +-12 (4*+-3) pro Symbol kompensiert werden.

Weiter werden fünf (11B12B) Kodierer und ein (7B8B) Kodierer verwendet deren maximale Disparität +-2 beträgt. Also im Extremfall erzeugen diese sechs Kodierer genau eine Disparität von +-12 (2*+-6). Diese kann sicher durch die 11B13B Kodierer kompensiert werden.

Das Verfahren erreicht gemäß einem Aspekt der vorliegenden Erfindung dieselbe Qualität wie ein 8B10B Code aber mit der Hälfte des Overheads (Verlust durch die Kodierung).

Die Implementierung der Kodier- und Dekodier- Hardware braucht nur minimale Ressourcen (Logik) auf Grund der Verwendung von mehreren kleinen Kodierern anstelle eines Großen.

Die Kodierung kann typischerweise komplett in einem Takt des parallelen Datenpfades erfolgen (kein Pipelining notwendig).

Die Steuerung der Disparität des 128 Bit Symbols kann mit (sehr) wenig Logik realisiert werden, und kann vollständig innerhalb eines Taktes des Datenpfades (langsam) realisiert werden, anstelle einer Berechnung der Disparität durch Zählen der eins und null Bits im seriellen Datenstrom mit dem sehr schnellen seriellen Takt.

Aufgrund der deterministischen Disparität und Lauflänge (Run Length) ist ein weiteres Scrambling nicht notwendig und damit ein schnelles Synchronisieren auf den Datenstrom Empfänger seitig möglich (keine Scramblersynchronisation nötig).

Dies ist unter anderem sehr nützlich für Power-Save-Modi in denen der Link zu Energiesparzwecken abgeschaltet und bei Bedarf wieder eingeschaltet werden kann. Hierfür ist eine schnelle Synchronisation zwischen Sender und Empfänger ein Muss.

Die Erfindung kodiert gemäß einem Aspekt der vorliegenden Erfindung ein 112 Bit breites Datenwort, mit beliebiger Disparität (Disparität max: 112) und beliebiger Lauflänge (Lauflänge max: 112), auf ein 128 Bit breites Symbol. Damit beträgt der durch die Kodierung entstehende Overhead 14.2%.

Die maximal in dem Symbol, wie auch bei beliebiger Sequenzierung beliebiger Symbole auftretende Lauflänge beträgt 8 gleiche Bits.

Die maximale Disparität im langen Mittel ist 0. Die Disparität in einem Symbol ist kleiner 9.

Dabei ist die Komplexität der Logik minimal, vergleichbar mit 10 8B/10B Kodierern (mit dem bekannten Nachteil des großen Overheads).

Erreicht wird dies durch den Einsatz, bzw. die parallele Verwendung von mehreren "kleinen" in ihrer Charakteristik bei Disparität und Lauflänge optimal aufeinander abgestimmten Kodierern.

Die Kodierer 11B12B, 7B8B und 6B8B erzeugen alle Symbole mit einer garantierten maximalen Lauflänge von 6, auch bei beliebiger Sequenzierung der (Teil)Symbole.

Der Kodierer (11B13B) erzeugt gemäß einem Aspekt der vorliegenden Erfindung Symbole mit einer garantierten maximalen Lauflänge von 7 bzw. am Anfang oder Ende des Symbols von 5. Auf Grund der Sequenzierung (Abb2) der (11B13B) mit den anderen Kodierern kann so maximal eine Lauflänge von 8 im Symbol entstehen.

Siehe Eigenschaften der Kodierer wie folgt:
Um die Komplexität der Hardware weiter zu reduzieren, werden vier kleine Kodierer (11B13B) verwendet, deren Disparität sich hinsichtlich Vorzeichen (+-) steuern lässt.

Die Steuerung der Symbol-Disparität erfolgt gemäß einem Aspekt der vorliegenden Erfindung derart, dass jeder Kodierer die Parität "seines" Teilsymbols berechnet. Dies geschieht mit wenig Aufwand, da das Teilsymbol nur wenige Bits aufweist.

Bei vier der elf Kodierern kann das Vorzeichen der Disparität des Teilsymbols durch die Invertierung des erzeugten Teilsymbols aktiv gesteuert werden. Dazu weisen die Kodierer (11B13B) die Besonderheit auf, dass deren Symbole für alle Eingangsdaten ein Symbol mit positiver Disparität (+3... +9) erzeugen. Durch Invertierung des Teilsymbols erhält man ein Symbol mit negativer Disparität (-3...-9).

So kann die Disparität (-2,-1,0,1,2) der Teilsymbole der anderen Kodierer (11B12B und 7B8B) kompensiert werden. Der Kodierer 6B8B erzeugt Symbole deren Disparität immer 0 ist. Dann werden alle (Teil) Paritäten der Kodierer (11B12B und 7B8B) addiert und das Ergebnis steuert die Entscheidung, wie viele invertierte und nicht-invertierte Symbole der Kodierer (11B13B) verwendet werden.

Dabei beträgt die mindeste (kleinste) Disparität des Kodierers 11B13B +-3. Also in Summe kann mit diesen vier Kodierern sicher eine Disparität von +-12 (4*+-3) pro Symbol kompensiert werden.

Weiter werden fünf (11B12B) Kodierer und ein (7B8B) Kodierer verwendet deren maximale Disparität +-2 beträgt. Also im Extremfall erzeugen diese sechs Kodierer genau eine Disparität von +-12 (2*+-6). Diese kann sicher durch die 11B13B Kodierer kompensiert werden.

Das Verfahren erreicht dieselbe Qualität wie ein 8B10B Code aber mit der Hälfte des Overheads (Verlust durch die Kodierung).

Die Implementierung der Kodier- und Dekodier- Hardware braucht nur minimale Ressourcen (Logik) auf Grund der Verwendung von mehreren kleinen Kodierern anstelle eines Großen.

Die Kodierung kann typischerweise komplett in einem Takt des parallelen Datenpfades erfolgen (kein Pipelining notwendig).

Die Steuerung der Disparität des 128 Bit Symbols kann mit (sehr) wenig Logik realisiert werden, und kann vollständig innerhalb eines Taktes des Datenpfades (langsam) realisiert werden, anstelle einer Berechnung der Disparität durch Zählen der eins und null Bits im seriellen Datenstrom mit dem sehr schnellen seriellen Takt.

Aufgrund der deterministischen Disparität und Lauflänge (Run Length) ist ein weiteres Scrambling nicht notwendig und damit ein schnelles Synchronisieren auf den Datenstrom empfängerseitig möglich (keine Scramblersynchronisation nötig).

Dies ist unter anderem sehr nützlich für Power-Save-Modi in denen der Link zu Energiesparzwecken abgeschaltet und bei Bedarf wieder eingeschaltet werden kann. Hierfür ist eine schnelle Synchronisation zwischen Sender und Empfänger ein Muss.

Figur 7B zeigt nunmehr die angepasste Systemanordnung aus Figur 7A, wobei nun entsprechende Teilvorwärtsfehlerkorrekturkodierer eingezeichnet sind. Diese werden vorliegend als FEC Block bezeichnet. Aus dieser Figur wird also ersichtlich, dass aus den Bitfolgen zuerst Segmente gebildet werden, was den oberen Pfeilen entspricht, die von den Nutzdaten abwärts gerichtet sind. Hier werden also die Teilvorwärtsfehlerkorrekturen erzeugt und sodann in die Kodiereinheiten eingespeist, wie diese bereits in Figur 7A ersichtlich sind. Die Leitungskodiereinheiten werden vorliegend als Line Coder bezeichnet und kodieren sowohl die Segmente der Bitfolgen als auch die Teilvorwärtsfehlerkorrekturen. In optionalen Verfahrensschritten kann noch die Parität justiert werden. Unten werden sodann die leitungskodierten Daten ausgegeben und nach rechts über einen potenziell fehlerbehafteten Kommunikationskanal an einen Empfänger, vorliegend nicht eingezeichnet, übersendet.

Figur 8A zeigt das erfindungsgemäße Verfahren zur Verbesserung der Vorwärtsfehlerkorrektur und zeigt insbesondere die Verfahrensschritte, welche senderseitig durchgeführt werden. Die Pfeile unten in der vorliegenden Figur 8A entsprechen dem Pfeil oben in der darauffolgenden Figur 8B. Die Daten werden also gemäß Figur 8A eingegeben und sodann erfolgt das Berechnen der Teilvorwärtsfehlerkorrektur. Wie oben ersichtlich ist, sind alle Segmente gleicher Bitlänge. D.h. also, dass die erste Spalte 11 Bit umfasst, die zweite Spalte 11 Bit umfasst und die letzte Spalte 6 Bit umfasst.

Über alle Segmente gleicher Bitfolge wird nunmehr eine Teilvorwärtsfehlerkorrektur erzeugt, die die gleiche Bitlänge hat, wie die entsprechenden Segmente. Hieraus ergeben sich die Daten mit einem Paritätssymbol. In einem abschließenden Verfahrensschritt erfolgt die serielle Leitungskodierung, welche beispielsweise 11 Bit auf 12 Bit abbildet oder 11 Bit auf 13 Bit abbildet oder 6 Bit auf 8 Bit abbildet. Diese Daten können nunmehr über den potenziell störungsanfälligen Kanal übertragen werden. Dies führt zu einer Übertragung wie sie in der Figur 8A unten eingezeichnet ist oder aber in der vorliegenden Figur 8B oben eingezeichnet ist.

Figur 8B zeigt das Verfahren auf Empfängerseite und entspricht dem Verfahren aus Figur 8A invers. Wie zusätzlich in der vorliegenden Figur 8B eingezeichnet ist, wird erkannt, dass Bit Fehler vorliegen können, die jedoch auf Segmentebene besonders vorteilhaft behandelt werden können. Die Bitfehler entstehen also nicht in der gesamten Bitfolge, sondern lediglich auf einzelnen Segmenten und können daher vorteilhaft behandelt werden. Dies führt zu den korrigierten Daten, wie sie in der Figur 8B unten eingezeichnet sind und es werden somit die 112 Bit zurückgewonnen, wie sie in der Figur 8A als Ausgang gedient haben.

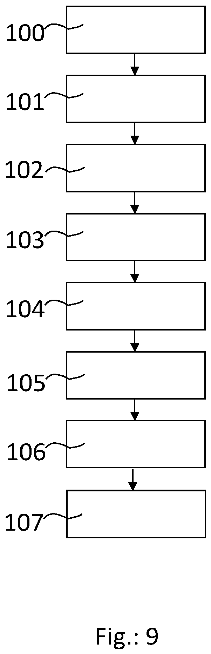

Figur 9 zeigt in einem Ablaufdiagramm ein Verfahren zur Verbesserung der Vorwärtsfehlerkorrektur bei serieller Kodierung bei einer Datenübertragung im Fahrzeug, aufweisend ein Bereitstellen 100 von zu übertragenden Nutzdaten; ein Aufteilen 101 der bereitgestellten Nutzdaten in eine Mehrzahl von Bitfolgen jeweils gleicher Länge; ein Auslesen 102 einer Unterteilungsvorschrift, welche eine Bitfolge in eine Abfolge von Segmenten jeweils vordefinierter Länge an vorbestimmter Bitposition unterteilt; ein Anwenden 103 der ausgelesenen Unterteilungsvorschrift auf alle Bitfolgen der Mehrzahl von Bitfolgen; ein iteratives Erstellen 104 jeweils einer Teilvorwärtsfehlerkorrektur für alle Segmente gleicher Bitposition über alle Bitfolgen; ein iteratives 105 Anwenden jeweils eines Segmentkodierers über jeweils alle Segmente gleicher Bitposition zur Erzeugung von Segmentleitungskodes über alle Segmente je Bitposition und je Bitfolge; ein Anwenden 106 jeweils desjenigen Segmentkodierers auf die jeweilige Teilvorwärtsfehlerkorrektur, der auch für die Segmente angewendet 105 wurde bezüglich derer die jeweilige Teilvorwärtsfehlerkorrektur erstellt 104 wurde zur Erzeugung jeweils eines Teilvorwärtsfehlerkorrekturleitungskodes je Teilvorwärtsfehlerkorrektur; und ein Übertragen 107 aller Segmentleitungskodes und aller Teilvorwärtsfehlerkorrekturleitungskodes.

Es erfolgt zudem ein Übertragen aller Segmentleitungskodes und aller Teilvorwärtsfehlerkorrekturleitungskodes: In diesem letzten Schritt werden alle erzeugten Segmentleitungskodes und Teilvorwärtsfehlerkorrekturleitungskodes übertragen. Diese übertragenen Codes enthalten die Informationen zur Fehlererkennung und -korrektur für die entsprechenden Segmente und Teilvorwärtsfehlerkorrekturen. Das beschriebene Verfahren ermöglicht eine verbesserte Vorwärtsfehlerkorrektur bei der seriellen Kodierung und Datenübertragung im Fahrzeug. Durch das Aufteilen der Nutzdaten in Segmente und die Anwendung spezifischer Kodierverfahren auf diese Segmente wird eine effektive Fehlererkennung und -korrektur auf Segmentebene erreicht.

Durch die iterative Erstellung einer Teilvorwärtsfehlerkorrektur für alle Segmente gleicher Bitposition und die Anwendung eines Segmentkodierers auf jedes Segment wird eine gezielte Fehlerkorrektur für die übertragenen Daten ermöglicht. Die Teilvorwärtsfehlerkorrekturleitungskodes enthalten die notwendigen Informationen, um Fehler zu erkennen und zu korrigieren, während die Segmentleitungskodes die Struktur und den Inhalt der Segmente repräsentieren und ebenfalls zur Fehlererkennung und -korrektur beitragen.

Durch die Übertragung aller erzeugten Segmentleitungskodes und Teilvorwärtsfehlerkorrekturleitungskodes kann der Empfänger die empfangenen Daten entsprechend analysieren und Fehler erkennen sowie korrigieren, um eine zuverlässige und genaue Übertragung der Nutzdaten im Fahrzeug zu gewährleisten.

Das beschriebene Verfahren bietet somit eine verbesserte Vorwärtsfehlerkorrektur, die insbesondere in anspruchsvollen Umgebungen wie Fahrzeugen, in denen Störungen und Signalverluste auftreten können, von großer Bedeutung ist. Es trägt zur Gewährleistung einer zuverlässigen und qualitativ hochwertigen Datenübertragung bei, was für verschiedene Anwendungen im Fahrzeugbereich von großer Bedeutung ist, wie beispielsweise autonomes Fahren, Fahrzeugsicherheitssysteme und Infotainment-Anwendungen.

Die Erfindung ermöglicht es stets zu jedem Zeitpunkt alle gewünschten Eigenschaften und Anforderungen an die serielle Kodierung bei effizientem Betrieb eines FECs beizubehalten. Durch die bewusste Positionierung des seriellen Kodierers nach den FEC-Einheiten ist das physikalische Verhalten auf dem Link stets deterministisch kontrollierbar (nicht der Fall bei Scrambler als serielle Kodierung).

Zudem wird durch die Wahl der FEC-Symbolgröße basierend auf der Datenwortgröße des jeweiligen seriellen Sub-Kodierers stets dafür gesorgt, dass Bitfehler immer minimal propagieren (ein defektes Leitungskode-Symbol erzeugt dann nur ein defektes FEC-Symbol).

Weiter wird durch die Verwendung von mehreren FEC-Sub-Kodierern eine sehr effiziente Art der sogenannten Verschachtelung (Interleaving) erzeugt. Dies ist ohne aufwändiges manuelles Verschachteln der Symbole möglich, was stets ein Vorhalten von Daten (mehr Latenz und Buffer) benötigen würde. Dies ermöglicht es auch Burstfehler z.B. 112/128 Bitfehler auf einmal zu korrigieren.

Nur durch den schematischen Aufbau in den Figuren 7A, 7B und 8A, 8B ist ersichtlich, dass dies der Fall ist: 128 Bitfehler führen in dem Falle zu jeweils nur einem einzigen Symbolfehler des jeweiligen FEC-Sub-Kodierers. Bei der klassischen Einzel-FEC-Kodierung würde ein gleich langer (128 fehlerhafte Bits in Folge) Burstfehler mehrere Symbolfehler hintereinander erzeugen. Dies kann je nach gewählter Kodierung dazu führen, dass das FEC-Wort (alle Symbole eines FEC-Zyklus) nicht mehr dekodiert werden können (damit ist dann auch eine Korrektur unmöglich). Normalerweise wird dies durch Verschachtelung (Interleaving) von Symbolen eines FEC-Zyklus mit denen eines oder mehrerer weiterer FEC-Zyklen erreicht. Dies ist allerdings nur unter Verwendung von Buffern sende- und empfangsseitig möglich um die Daten im Falle des Senders Verschachteln zu können und dieses im Empfänger wieder durch die inverse Operation in den ursprünglichen kontinuierlichen FEC-Symbol-Datenstrom der jeweils einzelnen FEC-Zyklen zu bringen. Durch die Verwendung mehrerer kleiner FEC-Kodierer wird die Verschachtelung und damit ebenfalls das Vorhalten von den für die Verschachtelung benötigten Buffern überflüssig (allerdings nur in gewissem Rahmen, ein Burstfehler von mehr als im Beispiel genannten 128 Bit in Folge führt dazu das pro individuellem FEC bereits mehr als ein Symbol beschädigt wird).

Wie viele Symbole ein jeweiliger FEC-Sub-Kodierer reparieren kann (t) ist abhängig von dem Overhead 2t siehe Abbildung 2. Dieser muss für die gewünschte Applikation entsprechend gewählt werden. Der in Figur 8A gezeigte Fall mit einem Symbolfehler pro FEC-Sub-Kodierer wird bereits bei t=1 (d.h. zwei Parity-Symbole Overhead) erreicht. Es ist ebenfalls anzumerken, dass der Burstfehler ebenfalls bedenkenlos ohne Einschränkungen im Bereich der Parity-Symbole passieren darf/ kann.

## Patentansprüche

1. Verfahren zur Verbesserung der Vorwärtsfehlerkorrektur bei serieller Kodierung bei einer Datenübertragung im Fahrzeug, aufweisend:
- ein Bereitstellen (100) von zu übertragenden Nutzdaten;
- ein Aufteilen (101) der bereitgestellten Nutzdaten in eine Mehrzahl von Bitfolgen jeweils gleicher Länge;
- ein Auslesen (102) einer Unterteilungsvorschrift, welche eine Bitfolge in eine Abfolge von Segmenten jeweils vordefinierter Länge an vorbestimmter Bitposition unterteilt;
- ein Anwenden (103) der ausgelesenen Unterteilungsvorschrift auf alle Bitfolgen der Mehrzahl von Bitfolgen;
- ein iteratives Erstellen (104) jeweils einer Teilvorwärtsfehlerkorrektur für alle Segmente gleicher Bitposition über alle Bitfolgen;
- ein iteratives (105) Anwenden jeweils eines Segmentkodierers über jeweils alle Segmente gleicher Bitposition zur Erzeugung von Segmentleitungskodes über alle Segmente je Bitposition und je Bitfolge;
- ein Anwenden (106) jeweils desjenigen Segmentkodierers auf die jeweilige Teilvorwärtsfehlerkorrektur, der auch für die Segmente angewendet (105) wurde bezüglich derer die jeweilige Teilvorwärtsfehlerkorrektur erstellt (104) wurde zur Erzeugung jeweils eines Teilvorwärtsfehlerkorrekturleitungskodes je Teilvorwärtsfehlerkorrektur; und
- ein Übertragen (107) aller Segmentleitungskodes und aller Teilvorwärtsfehlerkorrekturleitungskodes.

2. Verfahren nach Anspruch 1, **dadurch gekennzeichnet, dass** die Unterteilungsvorschrift in einem Datenspeicher abgespeichert ist, als eine Kodierungsvorschrift vorliegt und/ oder aus einer Hardwarearchitektur ausgelesen wird.

3. Verfahren nach Anspruch 1 oder 2, **dadurch gekennzeichnet, dass** alle Bitfolgen in ihrem Datenformat gleich aufgebaut sind, die gleichen Segmentlängen und/ oder die gleichen Bitpositionen aufweisen.

4. Verfahren nach einem der vorhergehenden Ansprüche, **dadurch gekennzeichnet, dass** die Teilvorwärtsfehlerkorrektur eine Korrekturinformation aufweist, welche einen Sollinhalt des Segments beschreibt über das die Teilvorwärtsfehlerkorrektur erstellt wurde.

5. Verfahren nach einem der vorhergehenden Ansprüche, **dadurch gekennzeichnet, dass** die Teilvorwärtsfehlerkorrektur die gleiche Bitlänge aufweist wie das Segment über welches diese erstellt wird.

6. Verfahren nach einem der vorhergehenden Ansprüche, **dadurch gekennzeichnet, dass** eine Gesamtheit der Teilvorwärtsfehlerkorrekturen alle zu übertragenden Nutzdaten korrigierbar beschreibt.

7. Verfahren nach einem der vorhergehenden Ansprüche, **dadurch gekennzeichnet, dass** die Segmentkodierer jeweils mindestens einen Teil eines Leitungskodes erzeugen.

8. Verfahren nach einem der vorhergehenden Ansprüche, **dadurch gekennzeichnet, dass** die Gesamtheit der Segmentkodierer Bitfolgen von 112 bit in Wörter von 128 bit kodiert.

9. Verfahren nach einem der vorhergehenden Ansprüche, **dadurch gekennzeichnet, dass** bei dem Übertragen (107) an die Segmentleitungskodes die Teilvorwärtsfehlerkorrekturleitungskodes angehängt werden.

10. Verfahren nach einem der vorhergehenden Ansprüche, **dadurch gekennzeichnet, dass** die Bitposition als ein Offset oder als ein Bitindex in der Bitfolge angegeben ist.

11. Verfahren nach einem der vorhergehenden Ansprüche, **dadurch gekennzeichnet, dass** die Nutzdaten als serieller Datenstrom vorliegen.

12. Verfahren nach einem der vorhergehenden Ansprüche, **dadurch gekennzeichnet, dass** die Verfahrensschritte in der beschriebenen Reihenfolge ausgeführt werden und/ oder iterativ ausgeführt werden.

13. Systemanordnung zur Verbesserung der Vorwärtsfehlerkorrektur bei serieller Kodierung bei einer Datenübertragung im Fahrzeug, aufweisend:
- eine Schnittstelleneinheit eingerichtet zum Bereitstellen (100) von zu übertragenden Nutzdaten;
- eine Aufteilungseinheit eingerichtet zum Aufteilen (101) der bereitgestellten Nutzdaten in eine Mehrzahl von Bitfolgen jeweils gleicher Länge;
- eine weitere Schnittstelleneinheit eingerichtet zum Auslesen (102) einer Unterteilungsvorschrift, welche eine Bitfolge in eine Abfolge von Segmenten jeweils vordefinierter Länge an vorbestimmter Bitposition unterteilt;
- eine Unterteilungseinheit eingerichtet zum Anwenden (103) der ausgelesenen Unterteilungsvorschrift auf alle Bitfolgen der Mehrzahl von Bitfolgen;
- eine Korrektureinheit eingerichtet zum iterativen Erstellen (104) jeweils einer Teilvorwärtsfehlerkorrektur für alle Segmente gleicher Bitposition über alle Bitfolgen;
- eine Kodiereinheit eingerichtet zum iterativen (105) Anwenden jeweils eines Segmentkodierers über jeweils alle Segmente gleicher Bitposition zur Erzeugung von Segmentleitungskodes über alle Segmente je Bitposition und je Bitfolge;
- eine weitere Kodiereinheit eingerichtet zum Anwenden (106) jeweils desjenigen Segmentkodierers auf die jeweilige Teilvorwärtsfehlerkorrektur, der auch für die Segmente angewendet (105) wurde bezüglich derer die jeweilige Teilvorwärtsfehlerkorrektur erstellt (104) wurde zur Erzeugung jeweils eines Teilvorwärtsfehlerkorrekturleitungskodes je Teilvorwärtsfehlerkorrektur; und
- eine Übertragungseinheit eingerichtet zum Übertragen (107) aller Segmentleitungskodes und aller Teilvorwärtsfehlerkorrekturleitungskodes.

14. Computerprogrammprodukt, umfassend Befehle, die bei der Ausführung des Programms durch mindestens einen Computer diesen veranlassen, die Schritte des Verfahrens nach einem der Ansprüche 1 bis 12 auszuführen.

15. Computerlesbares Speichermedium, umfassend Befehle, die bei der Ausführung durch mindestens einen Computer diesen veranlassen, die Schritte des Verfahrens nach einem der Ansprüche 1 bis 12 auszuführen.
